Europäisches Patentamt

European Patent Office

Office européen des brevets

(19)

(11) Numéro de publication : **0 147 493 B1**

# (12) FASCICULE DE BREVET EUROPÉEN

(45) Date de publication du fascicule du brevet :
07.09.88

(51) Int. Cl.⁴ : **G 01 B 11/27**

(21) Numéro de dépôt : 83430042.8

(22) Date de dépôt : 28.12.83

(54) Procédé et équipement pour l'alignement automatique d'un objet par rapport à une référence.

(43) Date de publication de la demande :
10.07.85 Bulletin 85/28

(45) Mention de la délivrance du brevet :
07.09.88 Bulletin 88/36

(84) Etats contractants désignés :
DE FR GB

(56) Documents cités :
EP-A- 0 054 596
EP-A- 0 054 598
DE-A- 2 907 647
DE-A- 2 934 454
DE-A- 2 934 603
US-A- 4 052 603
US-A- 4 365 163

(73) Titulaire : **International Business Machines Corporation**
**Old Orchard Road**
**Armonk, N.Y. 10504 (US)**
**DE GB**
**Compagnie IBM FRANCE**
**5 Place Vendôme**
**F-75000 Paris 1er (FR)**
**FR**

(72) Inventeur : **Linger, Claude Jacques André**
**13 rue des Haies**
**Paris 20ème (FR)**

(74) Mandataire : **Klein, Daniel Jacques Henri**
**Compagnie IBM France Département de Propriété**
**Intellectuelle**
**F-06610 La Gaude (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention concerne l'alignement automatique d'objets et, plus particulièrement, un procédé et un équipement pour l'alignement automatique d'un objet par rapport à une référence.

Diverses techniques sont utilisées dans l'industrie aux fins de l'inspection d'objets, tels que des circuits intégrés, fabriqués en grande série et de la détection d'éventuels défauts, de manière à corriger ces derniers et à diminuer le prix de revient.

Dans le cas, par exemple, de la fabrication de modules électroniques composés d'un substrat en céramique recouvert d'une configuration de métallisation assurant les liaisons électriques entre une microplaquette de silicium et des broches de connexion, il est indispensable de procéder à une telle inspection de manière à détecter la présence de défauts tels que courts-circuits, circuits ouverts, etc.

Dans l'art antérieur, l'inspection des configurations de métallisation, qui nécessitait l'alignement préalable des substrats, s'effectuait visuellement au moyen de microscopes. Cette méthode n'était pas fiable, parce que sujette à l'erreur humaine. D'autre part, en raison de son coût, elle se limitait à l'inspection d'un nombre restreint d'échantillons, représentant un pourcentage relativement faible de la production totale. Des modules défectueux pouvaient ainsi échapper aux contrôles effectués.

Des techniques d'inspection automatique ont donc été élaborées et sont décrites notamment, dans les demandes de brevet européen EP-A-54598 et EP-A-54596 déposées par la demanderesse le 18 décembre 1980. Toutefois, l'utilisation efficace de ces techniques dans le cas de substrats en céramique nécessite l'emploi d'une station d'alignement automatique des substrats.

De telles stations ont été proposées dans l'art antérieur et comportent généralement des dispositifs électro-optiques sophistiqués, tels que les systèmes de focalisation et de collimation décrits dans les brevets US-A-4052603, US-A-4365163, etc., permettant de comparer optiquement une ou plusieurs mires d'alignement, préalablement réalisées sur chaque substrat, avec une ou plusieurs mires de référence. La présence de ces dispositifs a pour effet d'augmenter la complexité de la station, ce qui n'est pas souhaitable. Par ailleurs, les mires d'alignement sont généralement réalisées en même temps que la configuration de métallisation et sont, comme elle, susceptibles de présenter des défauts qui compromettraient la précision de .l'alignement.

La présente invention permet de remédier à ces difficultés grâce à un procédé et à un équipement de conceptions originales, qui permettent d'aligner automatiquement un objet comportant deux mires d'alignement présentant une certaine surface, par rapport à une référence. L'invention est basée sur une comparaison, en termes de surface, entre l'image agrandie de chaque mire d'alignement et une image électronique (virtuelle) utilisée comme mire de référence générée au centre d'une fenêtre d'analyse. L'axe de référence est l'axe des centres des deux fenêtres d'analyse qui sont séparés d'une distance d. Le centre de référence est le point milieu des deux centres. Cette technique offre l'avantage de rendre inutile l'emploi de composants optiques coûteux et complexes, habituellement utilisés pour effectuer les comparaisons d'images ainsi que l'emploi de mires physiques de référence. En outre, elle réduit considérablement les effets néfastes provoqués par l'existence d'irrégularités dans le dessin des mires, inévitables lors de leur fabrication.

Brièvement exposée, l'invention concerne donc un procédé d'alignement automatique d'un objet muni de deux mires d'alignement séparées par une distance déterminée d et présentant une certaine surface, par rapport à une référence, constituée par deux fenêtres d'analyse d'image séparées par une distance d et définissant un axe et un centre de référence, ledit procédé comportant les étapes suivantes :

mise en place de l'objet sur une platine d'alignement ;

préalignement grossier, au moyen de techniques connues, dudit objet de telle sorte que l'image optique agrandie de chaque mire d'alignement ($I_{MIR}$, $I_{MIR}'$) s'inscrive dans une fenêtre d'analye d'image divisée en quadrants et dans laquelle l'image se trouve entièrement contenue ;

génération, au centre de chaque fenêtre d'analyse, de l'image d'une mire de référence virtuelle $I_{REF}$ de dimensions identiques à celle de l'image de la mire d'alignement ($I_{MIR}$, $I_{MIR}'$) et qui est superposée à cette dernière ;

détermination, pour chaque mire et pour chaque quadrant i (i = 1, 2, 3, 4), des surfaces des parties de l'image de la mire d'alignement ($I_{MIR}$, $I_{MIR}'$) qui s'étendent au-delà du contour de l'image de la mire de référence $I_{REF}$, c'est-à-dire non masquées par cette dernière et des surfaces des parties de l'image de la mire de référence $I_{REF}$ qui s'étendent au-delà du contour de l'image de la mire d'alignement ($I_{MIR}$, $I_{MIR}'$), c'est-à-dire masquées par cette dernière, ces superficies étant respectivement appelées « non masquées » ($S_i^+$, $S_i^{+\prime}$) et « masquées » ($S_i^-$, $S_i^{-\prime}$) ;

détermination par des moyens de calcul, à partir des valeurs desdites surfaces, des corrections en translation ($\Delta X$, $\Delta Y$) et en rotation ($\Delta\theta$) à apporter à ladite platine pour que l'objet qu'elle supporte, se trouve correctement aligné.

La présente invention concerne également un équipement de mise en œuvre dudit procédé d'alignement. Cet équipement comportant les moyens suivants :

des moyens de support pouvant être commandés en translation et en rotation, supportant ledit objet ;

des moyens d'analyse d'image comportant deux fenêtres d'analyse, dont chacune est divisée en quadrants, disposées de telle sorte que les images desdites mires d'alignement $I_{MIR}$, $I_{MIR}'$ soient entièrement contenues dans lesdites fenêtres d'analyse, et fournissant un signal binaire $I_{mir}$, $I_{mir}'$ pour chaque image analysée au moyen d'un balayage ligne par ligne desdites fenêtres ;

des moyens de génération d'un signal vidéo $I_{ref}$ correspondant à l'image $I_{REF}$ d'une mire de référence virtuelle, de dimensions identiques à celles de l'image de la mire d'alignement ($I_{mir}$, $I_{mir}'$) correspondante, le centre de ladite image $I_{REF}$ coïncidant virtuellement avec celui de la fenêtre d'analyse ;

des moyens de détermination, pour chaque mire et pour chaque quadrant (i = 1, 2, 3, 4), des surfaces des parties de l'image de la mire d'alignement ($I_{MIR}$, $I_{MIR}'$) qui s'étendent au-delà du contour de l'image de référence $I_{REF}$ et des surfaces des parties de l'image de référence $I_{REF}$ qui s'étendent au-delà du contour de l'image de la mire d'alignement ($I_{MIR}$, $I_{MIR}'$), ces parties étant respectivement appelées « non masquées » ($S_i^+$, $S_i^{+\prime}$) et « masquées » ($S_i^-$, $S_i^{-\prime}$) ; et

des moyens de calcul, à partir des valeurs desdites surfaces, des corrections en translation ($\Delta X$, $\Delta Y$) et en rotation ($\Delta\theta$) à apporter à ladite platine pour que l'objet qu'elle supporte se trouve correctement aligné par rapport à la référence.

La présente invention sera mieux comprise à la lecture de la description qui suit, faite en relation avec les dessins ci-joints, dans lesquels :

La figure 1 représente un substrat en céramique pourvu de deux mires d'alignement en forme de croix.

La figure 2 représente une fenêtre d'analyse constituée par une matrice de 100 × 100 photodiodes comportant une image d'une mire de référence parfaitement centrée.

La figure 3 représente la fenêtre d'analyse de la figure 2 comportant l'image agrandie d'une mire d'alignement $I_{MIR}$ décalée par rapport à l'image de référence $I_{REF}$.

La figure 4 permet de comprendre la présente méthode de calcul des corrections à apporter à la platine d'alignement pour obtenir un alignement correct de l'objet représenté sur la figure 1.

La figure 5 représente les différentes étapes du procédé d'alignement automatique de la présente invention pour l'objet représenté sur la figure 1.

La figure 6 représente l'architecture générale d'un équipement pour la mise en œuvre du procédé d'alignement automatique montré sur la figure 5.

La figure 7 représente de façon détaillée un mode de réalisation d'une moitié du démultiplexeur de la figure 6.

La figure 8 représente un mode de réalisation du sommateur de la figure 6.

La figure 9A représente la méthode d'écriture dans la mémoire morte contenue dans l'unité de génération du signal vidéo $I_{REF}$ de l'image de référence montré sur la figure 6.

La figure 9B représente l'unité de génération du signal binaire $I_{ref}$ de l'image de référence montré sur la figure 6.

La figure 10 représente l'unité de détermination des adresses des quadrants de la figure 6.

La figure 11 représente l'unité de détermination des valeurs des parties « masquées » et « non masquées » montrée sur la figure 6.

La figure 12 représente un chronogramme montrant la forme des signaux avant et après traitement dans le démultiplexeur montré sur la figure 6.

La description détaillée suivante concerne un mode de réalisation préféré de l'invention, dans lequel l'alignement automatique est assuré par un ordinateur industriel tel que le Système 1 IBM. Les objets à aligner sont des substrats en céramique munis de deux mires d'alignement présentant une certaine surface. L'alignement du substrat s'effectue par rapport à deux fenêtres d'analyse, séparées par une distance d, l'axe de référence est l'axe des centres des deux fenêtres, le centre de référence est le point milieu des deux centres. Pour chaque mire, les corrections sont calculées pour chaque fenêtre, par rapport à une image de référence virtuelle stockée dans une mémoire. Il doit être cependant compris que d'autres objets tels que des microplaquettes de circuits intégrés, des masques lithographiques, etc. sont susceptibles d'être alignés conformément aux enseignements de la présente invention.

Le procédé d'alignement de la présente invention est donc basé sur l'utilisation de deux mires (ou repères) d'alignement présentant une certaine surface, par exemple, deux petites croix formées en même temps que la métallurgie d'interconnexion et situées près de deux bords opposés du substrat en céramique, de part et d'autre d'un axe de symétrie médian. L'utilisation d'une seule mire, permet seulement un positionnement du substrat, mais non, son alignement précis.

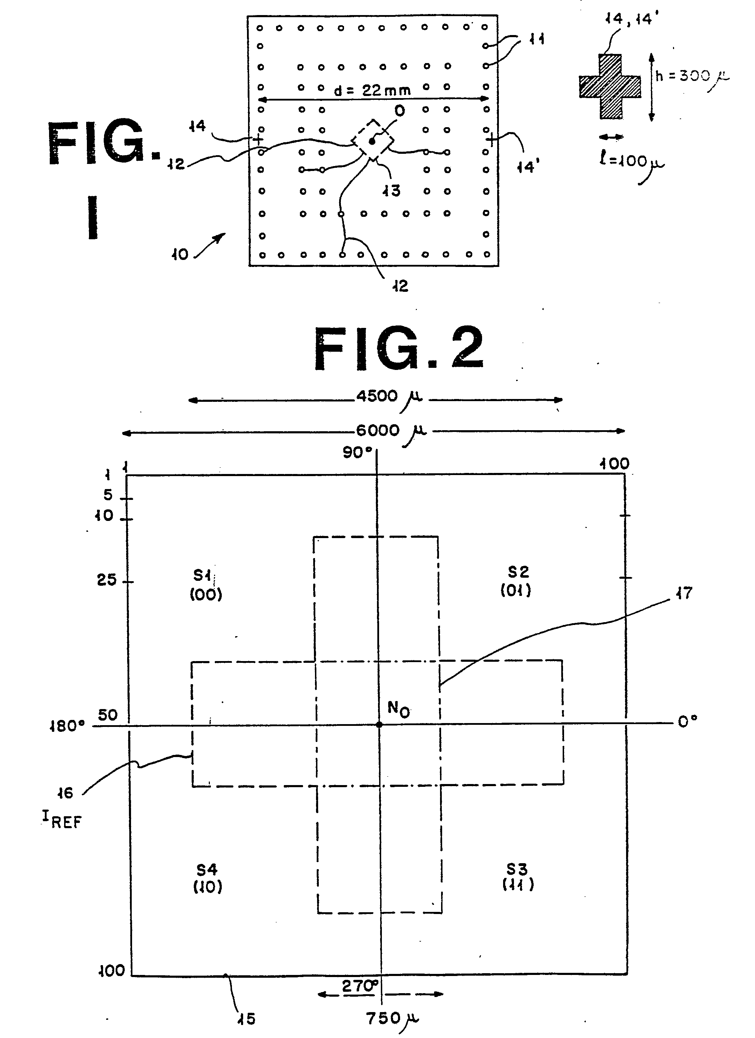

La figure 1 représente un tel substrat en céramique 10 de 24 × 24 mm², percé de trous 11 destinés à recevoir les broches (non représentées), et muni d'une configuration métallique d'interconnexion 12, qui assure la liaison électrique entre une microplaquette de silicium 13 et les broches. Ce substrat est muni de deux petites croix symétriques 14 et 14', disposées à une distance d = 22 mm l'une de l'autre et dont les dimensions l = 100 $\mu$ et h = 300 $\mu$ sont montrées sur la partie droite de la figure 1.

Selon l'invention, l'alignement du substrat placé sur une platine d'alignement comporte d'abord une étape de pré-alignement mécanique classique. On supposera que cette opération s'effectue avec une précision de 50 $\mu$, c'est-à-dire que le centre d'une croix de l'échantillon se trouve inclus dans un carré de 50 $\mu$, dont le centre coïncide avec le centre idéal recherché. Dans ces conditions, le décalage en rotation $\alpha$ d'une croix par rapport à sa position idéale est tel que sin $\alpha$ ‹ 50/100, soit $\alpha$ ‹ 0,25°, et n'est donc pas perceptible ; en d'autres termes, on peut raisonnablement considérer que pour faire coïncider la position réelle du centre d'une croix avec sa position théorique idéale, une correction angulaire en rotation est inutile, et que l'application de corrections en translation $\Delta x$ et $\Delta y$ pour amener le centre de la croix avec le centre idéal sera suffisante. Le calcul des corrections $\Delta x$ et $\Delta y$ à apporter à chaque croix est donc essentiel.

L'image de chaque mire est captée par une fenêtre d'analyse, ici constituée par des photo-diodes, dont le nombre et la configuration dépendent évidemment de la mire choisie et des conditions opératoires.

La figure 2 représente la matrice de photodiodes 15 (celle qui correspond à la croix d'alignement 14) découpée en quatre champs ou quadrants : S1, S2, S3 et S4 et de centre $N_0$. Sur cette figure, on a également représenté l'image d'une croix de référence $I_{REF}$ 16, parfaitement centrée dans la matrice. Dans le présent mode de réalisation, l'image de la croix de référence 16 ou image de référence $I_{REF}$, doit être comprise comme consistant en une image électronique générée automatiquement au cours du balayage des photodiodes de la matrice. L'image de référence est donc une image virtuelle. En fait $I_{REF}$ est présentée au centre de la fenêtre d'analyse aux seules fins de la simplification de l'exposé comme on le verra ci-après. Cette image $I_{REF}$ est générée de telle façon qu'elle présente des dimensions identiques à celle de l'image de la croix d'alignement ou image de la croix $I_{MIR}$.

Avec une optique qui a un grossissement G = 15, on choisira une matrice de 100 × 100 photodiodes, chaque photodiode constituant une zone photosensible élémentaire et adressable de 60 × 60 $\mu^2$ ; la dimension d'un élément d'image (pixel) du substrat et en particulier de ses croix, sera donc de 4 × 4 $\mu^2$. Après grossissement, l'image d'une croix d'alignement (h = 300 $\mu$m) aura donc pour dimensions 4 500 × 4 500 $\mu^2$ et se comparera donc avec une matrice de photodiodes de 6 000 × 6 000 $\mu^2$.

Chaque quadrant (p. ex S1) est identifié par une adresse binaire (p. ex. 00). La matrice de photodiodes étant une matrice de 100 lignes par 100 colonnes, chaque photodiode peut être adressée de façon indépendante, et les coordonnées x, y d'une photodiode adressée permettent de déterminer le quadrant de la matrice en cours d'investigation. La matrice de photodiodes est balayée ligne par ligne au rythme de l'horloge ; à chaque fin de ligne, le signal vidéo résultant est représentatif de la configuration balayée. Comme on l'a vu ci-dessus, le pré-alignement mécanique à 50 $\mu$m assure que le centre de l'image de la croix se trouve nécessairement dans un carré 17 de 750 $\mu$ (50 $\mu$m × 15) de côté, et de centre $N_0$.

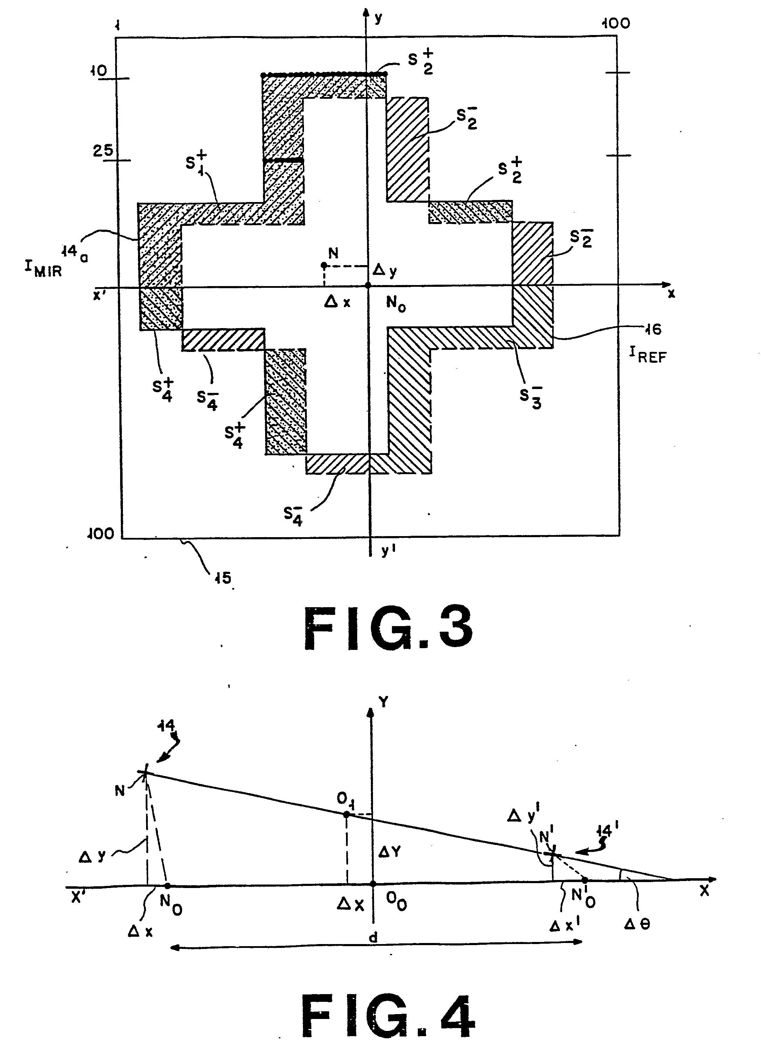

La figure 3 montre un exemple très exagéré de décalage de l'image $I_{MIR}$ de la croix 14a obtenue, après grossissement par un facteur G de la croix d'alignement 14, de telle sorte que son centre N soit décalé, dans le quadrant S1, des valeurs $\Delta x$ et $\Delta y$ par rapport au centre $N_0$ de la croix de référence. On remarque dans ce cas que $\Delta x < 0$ et $\Delta y > 0$, avec les axes xx' et yy' montrés sur la figure 3. Dans chaque quadrant i (i = 1, 2, 3 ou 4), on distingue les surfaces, dites « non masquées » ($S_i^+$) ou « masquées » ($S_i^-$) qui correspondent respectivement aux surfaces des parties de l'image de la croix qui s'étendent au-delà du contour de l'image de référence et aux surfaces des parties de l'image de référence qui s'étendent au-delà du contour de l'image de la croix.

Par exemple, on voit sur la figure 3 que, dans le cadran S1, l'image de la croix s'étend au-delà du contour de l'image de référence d'une surface dite « non masquée » $S_1^+$ ; alors que, dans le quadrant S3, c'est au contraire l'image de référence qui s'étend au-delà du contour de l'image de la croix d'une surface dite « masquée » $S_3^-$. On définit alors deux surfaces S' et S", telles que $S' = \Delta x \times H$ et $S'' = \Delta y \times H$ avec H = G × h ; expressions dans lesquelles H représente la hauteur de l'image de la croix (et donc aussi celle de l'image de référence). Les surfaces S' et S" peuvent être calculées de différentes façons à partir des surfaces $S_i^+$ et $S_i^-$. Dans le cas précis de la figure 3, où N se trouve dans le quadrant S1, on obtient tout d'abord les relations suivantes :

$$S' = (S_1^+ - S_3^-) + S_2^- + S_4^+ + (S_4^- - S_2^+)$$

$$S'' = (S_1^+ - S_3^-) + S_4^- + S_2^+ + (S_4^- - S_2^+)$$

qui peuvent se simplifier pour donner finalement :

$$S' = (S_1^+ - S_4^-) + S_4^+$$

$$S'' = (S_1^+ - S_2^-) + S_2^+$$

Il est par ailleurs remarquable de noter que, dans le cas où N se trouve dans le quadrant S1 d'adresse 00 ($\Delta x < 0$  $\Delta y > 0$), seule la valeur de la surface $S_1^-$ parmi les $S_i^-$ est nulle ; cette valeur $S_1^- = 0$ caractérise donc le cas où N se trouve dans le quadrant S1, c'est-à-dire un décalage de l'image de la croix d'alignement, vers le haut et vers la gauche, par rapport à la croix de référence.

En procédant de façon similaire pour les quatre quadrants, on peut regrouper les différents cas dans la table I suivante.

(Voir table page 5)

Table I

| QUADRANT (adresse) | SIGNE DES CORREC-TIONS | ELEMENT CARACTE-RISTIQUE | CALCUL DES CORRECTIONS | |
|---|---|---|---|---|
| $S_1$ (00) | $\Delta x < 0 \quad \Delta y > 0$ | $S_1^- = 0$ | $\Delta x = \dfrac{(S_1^+ - S_4^-) + S_4^+}{H}$ | $\Delta y = \dfrac{(S_1^+ - S_2^-) + S_2^+}{H}$ |
| $S_2$ (01) | $\Delta x > 0 \quad \Delta y > 0$ | $S_3^- = 0$ | $\Delta x = \dfrac{(S_2^+ - S_3^-) + S_3^+}{H}$ | $\Delta y = \dfrac{(S_2^+ - S_1^-) + S_1^+}{H}$ |
| $S_3$ (10) | $\Delta x > 0 \quad \Delta y < 0$ | $S_3^- = 0$ | $\Delta x = \dfrac{(S_3^+ - S_2^-) + S_2^+}{H}$ | $\Delta y = \dfrac{(S_3^+ - S_4^-) + S_4^+}{H}$ |
| $S_4$ (11) | $\Delta x < 0 \quad \Delta y < 0$ | $S_4^- = 0$ | $\Delta x = \dfrac{(S_4^+ - S_1^-) + S_1^+}{H}$ | $\Delta y = \dfrac{(S_4^+ - S_3^-) + S_3^+}{H}$ |

Les cas où le centre N se trouve placé sur un des axes $N_0x$ ou $N_0y$, se résolvent facilement. Par exemple, si $\Delta x = 0$, N se trouve sur l'axe $N_0y$ avec $\Delta y \neq 0$ on a alors $S_1^- = S_2^- = 0$, $S_1^+ = S_2^+$, $S_3^- = S_4^-$, et $S_3^+ = S_4^+ = 0$ ; on dérive de la table la valeur

$$\Delta y = 2S_1^+/H$$

On procède à cè calcul pour les deux croix 14 et 14', ce qui fournit finalement deux couples de valeurs $(\Delta x, \Delta y)$ et $(\Delta x', \Delta y')$. Pour tirer un maximum de profit du fait que la détermination de ces corrections est effectuée à partir d'un calcul de surface, on peut calculer les surfaces S' et S" différemment pour chaque quadrant, on obtient alors la table II suivante :

Table II

| QUADRANT (adresse) | SIGNE DES CORREC-TIONS | ELEMENT CARACTE-RISTIQUE | CALCUL DES CORRECTIONS | |
|---|---|---|---|---|
| $S_1$ (00) | $\Delta x < 0 \quad \Delta y > 0$ | $S_1^- = 0$ | $\Delta x = \dfrac{(S_3^- + S_2^-) - S_2^+}{H}$ | $\Delta y = \dfrac{(S_3^- - S_4^+) + S_4^-}{H}$ |
| $S_2$ (01) | $\Delta x > 0 \quad \Delta y > 0$ | $S_3^- = 0$ | $\Delta x = \dfrac{(S_4^- + S_1^-) - S_1^+}{H}$ | $\Delta y = \dfrac{(S_4^- - S_3^+) + S_3^-}{H}$ |
| $S_3$ (10) | $\Delta x > 0 \quad \Delta y < 0$ | $S_3^- = 0$ | $\Delta x = \dfrac{(S_1^- + S_4^-) - S_4^+}{H}$ | $\Delta y = \dfrac{(S_1^- - S_2^+) + S_2^-}{H}$ |
| $S_4$ (11) | $\Delta x < 0 \quad \Delta y < 0$ | $S_4^- = 0$ | $\Delta x = \dfrac{(S_2^- + S_3^-) - S_3^+}{H}$ | $\Delta y = \dfrac{(S_2^- - S_1^+) + S_1^-}{H}$ |

On considère dans la suite de cette demande que les corrections $(\Delta x, \Delta y)$ et $(\Delta x', \Delta y')$ sont obtenues, soit directement à l'aide d'une des deux tables, soit de préférence en faisant la moyenne des corrections fournies par deux tables. La pratique a montré que cette dernière solution donnait des résultats très supérieurs.

Il s'agit maintenant de déterminer à partir de ces valeurs, les corrections finales à apporter en translation $(\Delta X, \Delta Y)$ et en rotation $(\Delta \theta)$ à la platine d'alignement pour aligner parfaitement le substrat 10.

Le détail du calcul peut être compris à l'aide de la figure 4. Sur cette figure on a représenté en N et N', la position des centres des croix, 14 et 14', d'un substrat (non représenté) de centre $O_1$ qui doit être réaligné. $N_0$ et $N'_0$ représentent les positions des centres des fenêtres d'analyse séparées par une distance d et donc des points N et N' après réalignement. $O_0$ est le centre du substrat après réalignement mais également le centre de rotation de la platine d'alignement et le centre de référence. L'axe x'x des centres des fenêtres d'analyse est l'axe de référence pour l'opération d'alignement.

$\Delta x$ et $\Delta y$ représentent respectivement les corrections en x et y à apporter à la croix 14 pour ramener N en $N_0$.

$\Delta x'$ et $\Delta y'$ représentent respectivement les corrections en x et y à apporter à la croix 14' pour ramener N' en $N_0'$.

Les coordonnées de $O_1$ dans le système d'axes $XO_0Y$ sont donc $\Delta X$ et $\Delta Y$. $\Delta\theta$ est l'angle que fait la droite NN' avec l'axe X'X.

Etant donné que $\Delta\theta <<$, on peut considérer que $\sin\Delta\theta \simeq 0$ et $\cos\Delta\theta \simeq 1$. Avec ces approximations, on trouve :

$$\Delta X = (\Delta x + \Delta x')/2, \ \Delta Y = (\Delta y + \Delta y')/2 \text{ et } \Delta\theta = (\Delta y - \Delta y')/2d$$

Si $\Delta y \le \Delta y'$, alors $\Delta\theta \le$ et si $\Delta y > \Delta y'$, alors $\Delta\theta > 0$.

Après l'application des corrections $\Delta X$ et $\Delta Y$, le centre du substrat $O_1$ correspond au centre idéal $O_0$, l'alignement parfait et définitif étant alors obtenu après une rotation d'angle $\Delta\theta$ autour du centre $O_0$.

L'avantage de ce procédé d'alignement sur les procédés de l'art antérieur est qu'il est basé sur le calcul de surfaces, telles que $S_i^-$ et $S_i^+$, ce qui permet de compenser les irrégularités dans le dessin des croix, qui sont inévitables parce qu'inhérentes au procédé de métallisation. Ce procédé, notamment quand on procède à la moyenne des corrections fournies par les tables I et II permet pratiquement de s'affranchir de défauts géométriques de la croix et donc d'assurer un alignement plus précis que celui assuré par les procédés de l'art antérieur.

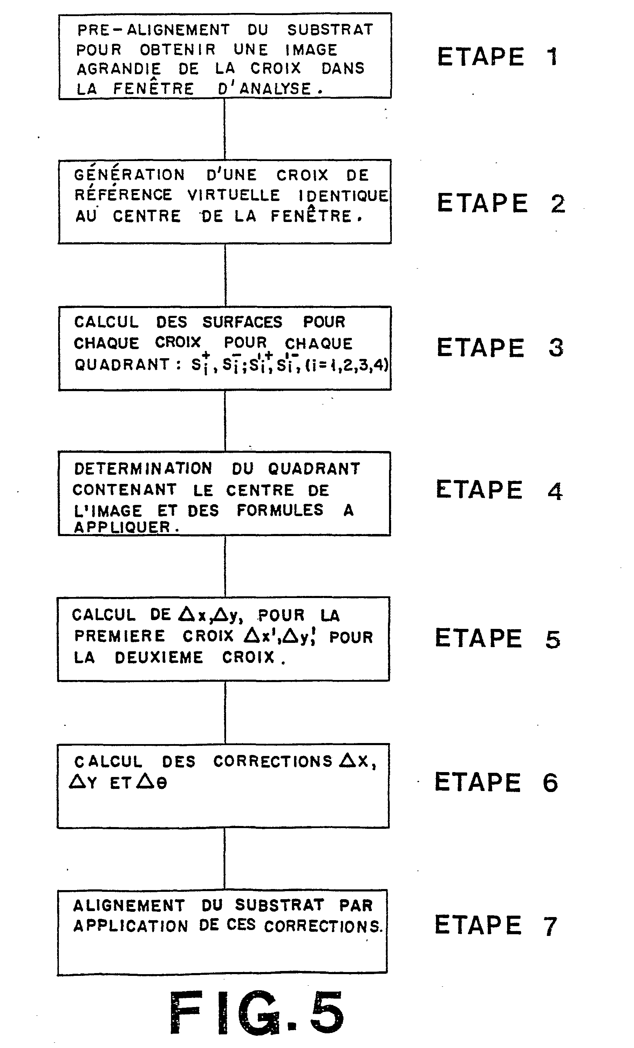

La figure 5 montre la séquence des différentes étapes du présent procédé tel qu'on vient de le décrire.

L'étape 1 consiste donc dans le préalignement mécanique du substrat, ce qui assure un alignement relativement grossier des deux croix d'alignement par rapport à leurs positions idéales. Par exemple, avec une précision de 50 $\mu$, on est certain que le centre N (N') de la croix 14 (14') sera contenu dans un carré de centre $N_0$ ($N_0'$) et de 750 $\mu$ de côté (50 $\mu \times 15$). Dans ces conditions, l'image agrandie de chaque croix d'alignement du substrat est incluse dans la fenêtre d'analyse (15, 15') qui lui correspond.

A l'étape 2, on génère virtuellement l'image d'une croix de référence de dimensions identiques à celles de l'image de la croix d'alignement au centre de chaque fenêtre d'analyse.

A l'étape 3, on calcule pour chaque quadrant et pour chaque croix les surfaces « non masquées » et « masquées » : $S_i^+$, $S_i^-$ respectivement, pour la première croix et $S_i^{+'}$, $S_i^{-'}$ pour la seconde croix. On notera que i = 1, 2, 3, 4.

A l'étape 4, des moyens de calcul déterminent pour chaque croix la valeur caractéristique $S_i^-$ qui est nulle, pour en déduire les relations à appliquer, d'après la table (ou les tables) montrée(s) ci-dessus. Ces relations permettent de déterminer les corrections $\Delta x$, $\Delta y$ pour la première croix et $\Delta x'$, $\Delta y'$ pour la seconde croix.

A l'étape 5, les moyens de calcul élaborent ces deux couples de valeurs.

A l'étape 6, les moyens de calcul déterminent les valeurs des corrections finales en translation $\Delta X$, $\Delta Y$, et en rotation $\Delta\theta$ à appliquer à la table d'alignement pour obtenir un alignement parfait, lequel est effectué lors de l'étape 7. Après application de ces corrections à la platine d'alignement, le substrat se trouve parfaitement aligné, les opérations d'analyse et de tri peuvent commencer.

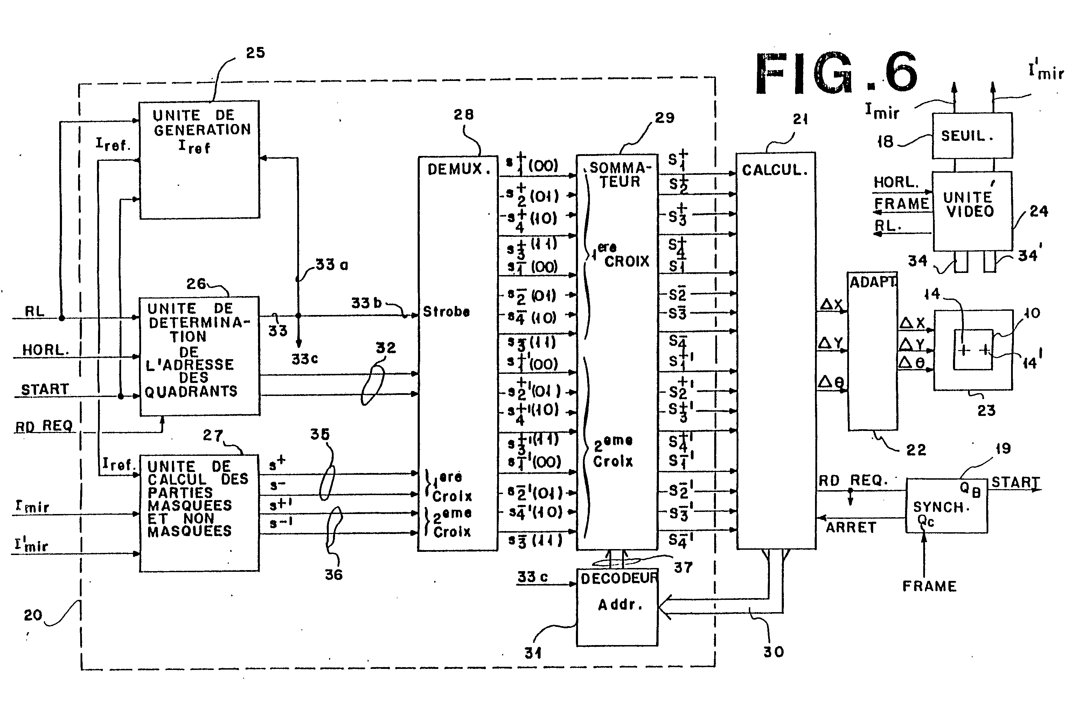

Un exemple d'équipement qui permet de mettre en œuvre le procédé de la présente invention qui vient d'être décrit, est montré sur la figure 6. Cette figure représente schématiquement sous forme de blocs, l'architecture d'un tel équipement qui porte la référence 20 et auquel on associe des moyens de calcul 21, un adaptateur 22 qui commande les déplacements d'une platine d'alignement 23 portant le substrat 10 à aligner, et une unité vidéo 24 qui fournit les signaux vidéo correspondant respectivement aux images des croix d'alignement $I_{MIR}$ et $I_{MIR}'$. Ces signaux vidéo sont seuillés dans le bloc 18, en sortie de ce dernier, on trouve les signaux binaires $I_{mir}$ et $I_{mir}'$ correspondants à $I_{MIR}$ et $I_{MIR}'$. Par la suite, on entendra par moyens d'analyse l'ensemble constitué par l'unité vidéo 24 et le bloc 18.

Le système 20 comporte tout d'abord des moyens de génération 25 de l'image de référence, des moyens de calcul 26 qui déterminent à tout moment l'adresse du quadrant de la photodiode adressée et des moyens de calcul 27 qui déterminent, ligne par ligne et pour chaque croix, les valeurs des parties élémentaires « non masquées » ($s^+$, $s^{+'}$) et « masquées » ($s^-$, $s^{-'}$). Le système 20 comporte en outre un démultiplexeur 28, qui répartit ces valeurs des parties élémentaires $s^+$, $s^{+'}$, $s^-$, $s^{-'}$ pour chaque quadrant et un sommateur 29 qui intègre toutes les valeurs élémentaires, pour fournir pour chaque croix et pour chaque quadrant, les valeurs des surfaces « non masquées » et « masquées » ($S_i^+$, $S_i^-$ ; $S_i^{+'}$, $S_i^{-'}$) selon les définitions données précédemment. Ces dernières valeurs sont fournies par le sommateur 29 aux moyens de calcul 21 quand ces derniers en feront la demande via le bus 30 et le décodeur 31.

L'opération d'alignement débute par le chargement du substrat 10 sur la platine d'alignement 23. Les moyens de calcul 21 commandent d'abord l'opération de préalignement mécanique, puis se déclarent prêts au calcul des corrections, en transmettant aux moyens 25 et 26, un signal approprié sur la ligne START en agissant sur le bloc de synchronisation 19 par le signal RD REQ.

Mais les résultats fournis par le premier balayage ne doivent pas être validés. En effet, l'instant où le substrat est parfaitement aligné, peut se trouver aléatoirement entre le début et la fin du balayage de l'image, puisque celui-ci est effectué en permanence (dans cette application). Le contenu des compteurs ne correspondrait pas aux surfaces $S_i^+$ ... $S_i^{-\prime}$ recherchées. Par conséquent, quand un module est aligné, la première impulsion de FRAME (signal de fin d'image) doit être ignorée, le contenu des compteurs ne sera pris en considération qu'à la deuxième impulsion de FRAME, car alors seulement un balayage complet aura été effectué, le travail de chargement des compteurs s'effectuant entre ces deux impulsions. Le signal START qui commande les blocs 25 et 26 ne sera validé qu'entre ces deux impulsions.

Le bloc de synchronisation 19 est simplement un registre à décalage. Le signal FRAME est appliqué sur l'entrée « CLOCK » et le signal RD REQ sur l'entrée « PRESET ». Le signal START est disponible sur la sortie $Q_B$. La sortie $Q_C$ qui passe au niveau haut à la deuxième impulsion FRAME (quand la sortie $Q_A$ passe au niveau bas) fournit un signal ARRET qui permet aux moyens de calcul 21 de savoir que les compteurs du sommateur 29, contiennent bien l'information recherchée et qu'ils peuvent procéder au calcul des corrections.

Les moyens de calcul 26 déterminent à tout moment, et pour chaque photodiode adressée, le quadrant (ex. S1) et donc l'adresse (ex. 00) qui lui correspond ; cette adresse est fournie au démultiplexeur 28 par les fils 32. Deux bits suffisent pour définir l'adresse du quadrant. Les moyens 26 reçoivent le signal d'horloge du système et engendrent des signaux de synchronisation internes qui sont transmis aux moyens de génération 25 et au démultiplexeur 28 par les fils 33a et 33b respectivement. Ils reçoivent enfin de l'unité vidéo 24, un signal de fin de ligne ou synchronisation ligne référencé RL.

Outre le signal START, les moyens de génération 25 reçoivent le signal de fin de ligne RL et le signal de synchronisation interne par la ligne 33a comme on l'a vu ci-dessus. En retour, ils fournissent $I_{ref}$ (qui est le signal binaire représentatif de l'image de référence virtuelle $I_{REF}$ montrée sur la figure 3) aux moyens 27 de calcul logique des parties « masquées » et « non masquées ».

Ces moyens 27 reçoivent simultanément et en parfait synchronisme, le signal binaire $I_{ref}$ et les signaux binaires $I_{mir}$ et $I_{mir}'$ fournis par les dispositifs 34 et 34' associés à l'unité vidéo 24 après seuillage dans le bloc 18. Chacun de ces dispositifs (34 et 34') consiste essentiellement en une matrice de photodiodes comme cela a été dit ci-dessus, qui reçoit l'image agrandie (14a, 14'a) de la croix d'alignement (14, 14'). C'est dans les moyens 27 que s'élabore, ligne par ligne, le calcul des valeurs élémentaires qui une fois sommées pour toute l'image fourniront des valeurs représentatives des surfaces ($S_i^+$, $S_i^-$, $S_i^{+\prime}$, $S_i^{-\prime}$).

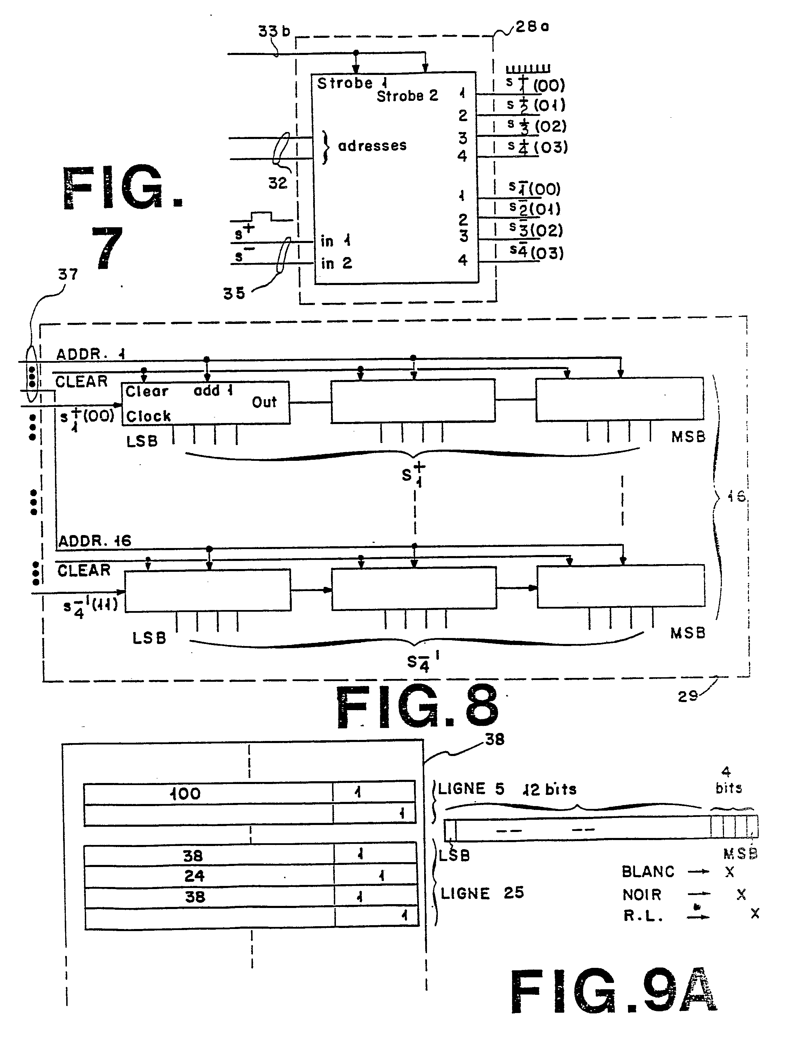

Pour chaque ligne de la matrice de photodiodes, les moyens 27 délivrent après balayage de la ligne un signal, dont la durée sera représentative de la longueur des parties élémentaires « non masquées » ($s^+$) et « masquées » ($s^-$) traversées. Par exemple, lors du balayage de la 25e ligne (voir figure 3), la traversée des parties « non masquées » et « masquées » correspond à environ 8 photodiodes chacune, les moyens 27 fourniront des signaux $s^+ = 8T$ et $s^- 8T$, où T est la période de l'horloge du système, puisqu'on balaye une diode par période. Pour la dixième ligne, on aurait obtenu de le même façon, $s^+ = 24T$, qui correspond à la traversée des 20 photodiodes correspondant à $S_1^+$ et des 4 photodiodes correspondant à $S_2^+$. En effet, les valeurs fournies par les moyens 27 ne précisent pas le quadrant. Les signaux représentatifs des valeurs $s^+$, $s^-$ pour la première croix, et $s^{+\prime}$, $s^{-\prime}$ pour la seconde croix, sont respectivement transmis au démultiplexeur 28 par les fils 35 et 36. Ce sont les moyens de calcul 26 qui permettent au démultiplexeur 28, par les fils 32, de déterminer le quadrant correspondant, c'est-à-dire dans l'exemple précédent, de savoir que $s^+ = 24$ est composé de $s_1^+(00) = 20$ relatif au quadrant S1 (adresse 00), et de $s_2^+(01) = 4$ relatif au quadrant S2 (adresse 01). Dans cette réalisation, le démultiplexeur 28 est en fait, composé de deux parties identiques 28a et 28b, dont chacune est constituée par un module du type SN74155 classique et représenté sur la figure 7. Cette figure montre clairement le détail des connexions à réaliser pour le traitement correct des valeurs $s^+$ et $s^-$ (fils 35). Un autre module (non représenté) est monté de façon similaire pour le traitement des valeurs $s^{+\prime}$ et $s^{-\prime}$ (fils 36). Le démultiplexeur 28 convertit les signaux binaires représentant ces valeurs $s^+$, $s^-$, $s^{+\prime}$, $s^{-\prime}$, en séries d'impulsions qui sont transmises vers le sommateur 29, au rythme du signal de synchronisation interne appliqué à son entrée « STROBE » par le fil 33b.

Cette conversion est commode, car ces impulsions représentatives des signaux $s_i^+$, $s_i^-$, $s_i^{+\prime}$, $s_i^{-\prime}$ seront ultérieurement totalisées dans des compteurs. Par exemple, toutes les valeurs $s_1^+$ obtenues ligne par ligne et relatives au quadrant S1, sont sommées dans le sommateur 29, le total obtenu, fourni sous la forme d'un mot binaire, sera représentatif de la surface $S_1^+$.

Le sommateur 29 est constitué par seize compteurs à 12 bits pour pouvoir chacun compter jusqu'à une valeur maximale de $50 \times 50 = 2\,500$ pixels dans le présent exemple où la matrice de photodiodes est $100 \times 100$, est adressable à partir du décodeur 31 sous le contrôle des moyens de calcul 21. Dans la présente réalisation, pour des raisons pratiques chacun desdits compteurs est remplacé par trois compteurs à 4 bits du type à trois états connu sous la référence DM8556. Ce mode de réalisation est montré sur la figure 8, avec le détail des connexions. Cette figure montre bien que les valeurs $S_1^+$ ... $S_4^{-\prime}$, sont disponibles en sortie sous la forme de mots binaires de 12 bits.

Enfin, quand l'ensemble des photodiodes a été balayé, le contenu de chaque compteur est représentatif d'une valeur $S_i^+$, $S_i^-$ pour la première croix, et $S_i^{+\prime}$, $S_i^{-\prime}$ pour la deuxième croix. Comme on l'a dit ci-dessus, quand le bloc de synchronisation 19 fournit le signal ARRET aux moyens de calcul 21, ces derniers lisent successivement les différentes valeurs $S_1^+$, $S_2^+$, ..., $S_4^{-\prime}$ qui sont contenues dans les compteurs, en appliquant les adresses appropriées au décodeur 31 par le bus 30. Ce bus comprend 4 fils,

**0 147 493**

qui sont connectés aux entrées ADDR. Le décodeur 31 qui reçoit par ailleurs le signal de synchronisation interne par le fil 33c, comporte donc un bus de sortie 37 comprenant 16 fils (ADDR.1 ... ADDR.16), qui sont respectivement reliés aux entrées ADDR. des différents compteurs constituant une rangée de compteurs, comme cela ressort de la figure 8. Les adresses des différentes rangées de compteurs sont stockées dans la mémoire des moyens de calcul 21. Le décodeur peut être constitué par un module commercialisé sous la référence SN74154. l'entrée CLEAR de chacun des compteurs est reliée à une ligne CLEAR, qui permet leur remise à zéro sous le contrôle des moyens de calcul 21, une fois les valeurs $S_1^+$, $S_2^+$ ... $S_4^-$ lues.

Les moyens de calcul 21, par exemple, un IBM système 1, déterminent d'abord les valeurs intermédiaires $\Delta x$, $\Delta y$ et $\Delta x'$, $\Delta y'$, puis en déduisent les valeurs des corrections $\Delta X$, $\Delta Y$ et $\Delta \theta$ nécessaires à l'alignement de la platine, en utilisant les formules appropriées parmi celles rassemblées dans la(les) table(s) détaillée(s) ci-dessus.

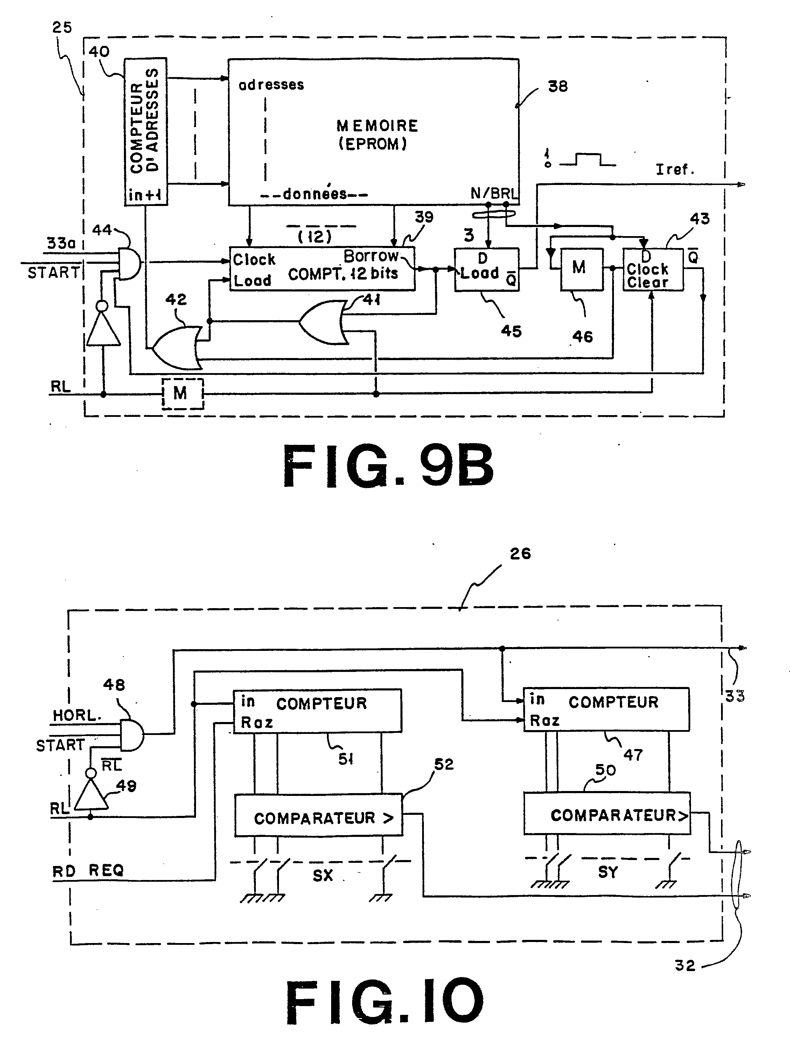

Le fonctionnement des moyens de génération 25 de $I_{REF}$ sera mieux compris à l'aide des figures 9A et 9B. Les moyens 25 génèrent des mots de 16 bits de deux types : mots de données et séparateurs, dont le format est indiqué sur la figure 9A. Pour les mots de données, les douze premiers bits représentent la valeur binaire du nombre de pixels (points noirs et points blancs successifs) que comporte une ligne donnée. Par exemple, la cinquième ligne de la figure 2, de la fenêtre d'analyse ne comporte que des blancs (absence d'image), soit 100 blancs, les moyens 25 généreront l'équivalent binaire de « 100 » ; pour la 25e ligne qui traverse $I_{REF}$ et qui comporte successivement environ 38 blancs, 24 noirs et 38 blancs (en abrégé 38B-24N-38B), il génèreront successivement les équivalents binaires des valeurs « 38 », « 24 » et « 38 », comme cela est représenté sur la figure 9A. Les quatre autres bits, dont trois seulement sont utilisés sont des indicateurs. Deux bits indiquent si les pixels sont noirs (indicateur N) ou blancs (indicateur B), le troisième bit est l'indicateur RL qui correspond au signal de fin de ligne RL. Ce signal RL passe au niveau haut, à la fin du balayage d'une ligne, pendant 8 périodes d'horloge T, avant de redescendre au niveau pendant toute la durée du balayage de la ligne suivante.

Entre chaque paquet de mots de données, constitué par une série de mots de 16 bits, et représentant une ligne, on dispose un mot de séparation ou séparateur (S), qui est lui aussi un mot de 16 bits. Le séparateur S ne comporte aucune indication numérique dans ses douze premiers bits, il se caractérise par la seule présence du bit indicateur RL. Tous ces mots représentatifs d'une ligne, sont successivement stockés dans une mémoire 38, qui peut être du type EPROM, par exemple celle commercialisée sous la référence MM2716.

Le premier mot de données emmagasiné à l'adresse 0 est chargé dans le registre décompteur 39 de la figure 9B, lors d'une séquence d'initialisation qui comporte essentiellement la restauration de l'ensemble des circuits de la figure 9B et notamment du registre 39 et du compteur d'adresse 40 de la mémoire. Le deuxième mot de données ne sera chargé dans le registre 39 que lorsque la sortie « BORROW » de celui-ci, engendrera une impulsion, c'est-à-dire quand le contenu du registre passera par 0, à la fin du décomptage du premier mot de données. Outre ce chargement, cette impulsion provoque l'incrémenta-tion du compteur d'adresses 40 à travers les portes « OU » 41 et 42. Admettons que le registre 39 achève de décompter le mot de donnée 38B, alors que la sortie $\bar{Q}$ de la bascule 45 est au niveau bas, c'est-à-dire $I_{ref} = 0$. Le mot de donnée suivant, soit 24N, est disponible sur le bus de sortie de la mémoire 38. Quand le contenu du registre 39 passe par 0, sa sortie « BORROW » délivre une impulsion sur l'entrée CLOCK de la bascule de type D45, qui change alors d'état (les indicateurs précédents B = 1, N = 0 correspondants au mot de données 38B, sont devenus B = 0, N = 1 avec le mot de données 24N). Il suffit pratiquement d'attaquer l'entrée D de la bascule 45, soit avec l'indicateur B, soit avec l'indicateur N, c'est pourquoi sur la figure 9B, on a représenté l'indicateur N/B.

La sortie $\bar{Q}$ de la bascule 45 passe à l'état haut, c'est-à-dire $I_{ref} = 1$ simultanément, l'impulsion délivrée sur la sortie « BORROW », autorise le chargement de la valeur 24 correspondant au mot de données 24N dans le registre 39 en agissant sur son entrée « LOAD » à travers la porte OU 41 et de plus incrémente d'une unité le compteur d'adresse 40 à travers la porte OU 42 en appliquant l'impulsion sur l'entrée « IN + 1 » du compteur 40. Le mot suivant soit 38B est alors disponible sur le bus de sortie de la mémoire.

Le registre 39 décompte donc à partir de 24 jusqu'à 0 au rythme de l'horloge (fil 33a) appliquée à travers la porte ET 44. On sait que le signal START est au niveau 1 pendant toute la durée du balayage de l'image entre deux impulsions « FRAME ». Le signal de fin de ligne RL, ne peut bloquer cette porte qu'en fin de ligne (alors RL = 1 et $\overline{RL}$ = 0), pendant une durée de 8T. On a donc $I_{REF} = 1$ pendant toute la durée de décomptage, c'est-à-dire pendant 24T.

Quand le contenu du registre 39 passe par 0, l'état de la bascule 45 va de nouveau changer, l'indicateur N/B (puisque 38B est disponible sur le bus de sortie) et $I_{ref}$ va de nouveau descendre à 0.

Mais le séparateur S devient alors disponible sur le but de sortie et le bit indicateur RL, au niveau 1, remis en forme dans le monostable 46, et appliqué sur l'entrée « CLOCK » de la bascule de type D43, valide le bit indicateur RL sur l'entrée D ; la sortie $\bar{Q}$ passe alors à 0, bloquant le décomptage de 38 à 0, en bloquant la transmission du signal d'horloge (fil 33a) au registre 39. Le signal $I_{ref}$ reste au niveau 0, jusqu'à l'apparition du signal RL qui est appliqué sur l'entrée CLEAR de la bascule 43, et va relancer le décomptage pour le début de la ligne suivante. Cette solution plus complexe que s'il s'était agit de décompter de 38 à 0 avant de passer à la ligne suivante, permet d'avoir toujours un parfait synchronisme du décomptage avec le retour ligne (RL). Le signal de retour ligne RL peut être, soit appliqué directement

8

sur l'entrée CLEAR de la bascule, soit de préférence à travers un monostable M.

La figure 10 représente un mode de réalisation des moyens de détermination de l'adresse des quadrants 26. On sait qu'avec une matrice de N × N photodiodes, on a N lignes et N colonnes et que l'on change de quadrant à partir de N/2 lignes et/ou de N/2 colonnes. Dans le cas présent, N est égal à 100 (voir figures 2 et 3). Les impulsions d'horloge sont totalisées dans un compteur de colonnes 47 jusqu'à l'apparition du signal de fin de ligne (RL) qui est appliqué à la porte ET 48 à travers l'inverseur 49 qui remet le compteur 47 à zéro. Le contenu de ce compteur 47 constitue la première entrée d'un comparateur 50. L'autre entrée de ce dernier est la valeur « 50 » définie par une série de commutateurs SY. A la 51$^e$ impulsion, la sortie « plus grand que », passe à 1 et est envoyée à l'entrée d'adressage du démultiplexeur par un des deux fils 32. Le compteur de lignes 51 et le comparateur 52 qui lui est associé fonctionnent de façon analogue en ce qui concerne les lignes donc en comptant les signaux de fin de ligne (RL). La remise à zéro du compteur de lignes 51 s'effectue au départ par le signal RD REQ. fourni par les moyens de calcul 21. L'état binaire (par exemple 00) des fils 32 est représentatif du quadrant (par exemple S1) en cours d'investigation dans la fenêtre d'analyse. On remarque que le signal de synchronisation interne, transmis sur le fil 33, est identique au signal d'horloge du système, sauf lors de la présence soit du niveau haut du signal de fin de ligne RL, donc $\overline{RL} = 0$, soit du niveau bas du signal START, pendant laquelle il est inhibé.

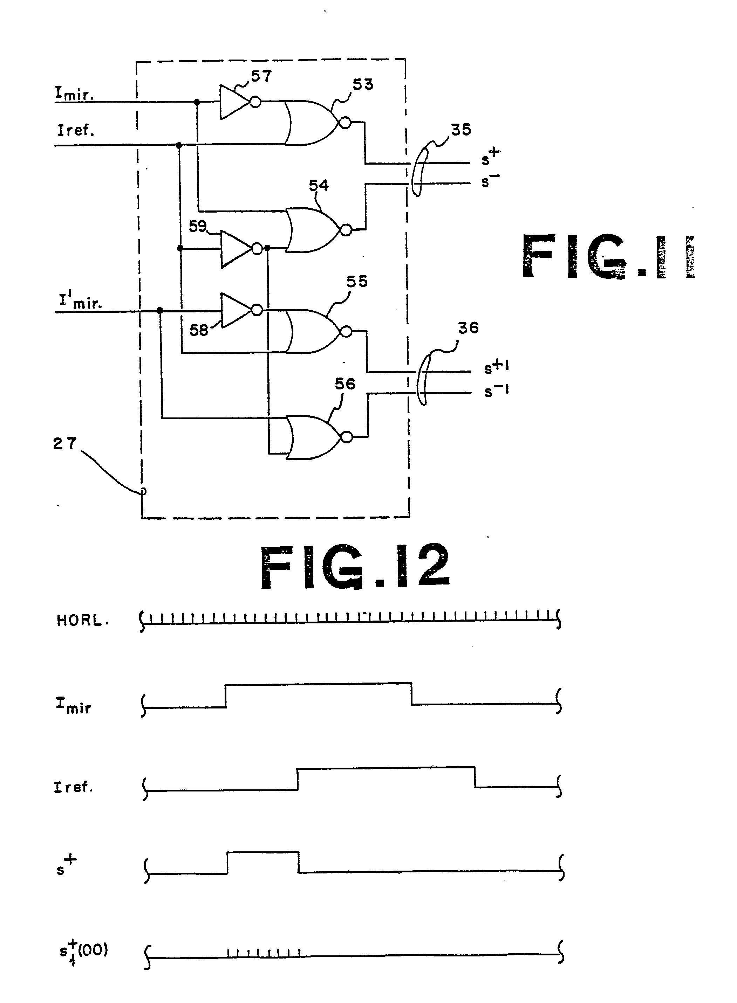

La figure 11 représente un mode de réalisation des moyens 27 de calcul des parties « non masquées » et « masquées ». Comme il s'agit simplement de soustraire des signaux binaires, cela peut être réalisé avec quatre portes NOR 53 à 56 et trois inverseurs 57, 58 et 59. Par exemple, on obtient $s^+ = \overline{I_{mir} + I_{ref}}$ ; ce qui représente bien l'extension de l'image de la croix $I_{MIR}$ par rapport à l'image $I_{REF}$ pour une ligne donnée.

La figure 12 représente les chronogrammes des différents signaux pour une ligne déterminée (par exemple, pour la ligne 25). Elle montre en particulier comment le signal binaire $s^+$ est échantillonné dans le démultiplexeur au rythme du signal de synchronisation interne (identique au signal d'horloge, sauf en fin de ligne), qui est appliqué à son entrée « strobe ». L'adresse affichée sur les fils 32 est dans ce cas (00), le signal $s_1^+$ (00) à la sortie du démultiplexeur aura donc la forme représentée, c'est-à-dire qu'il sera constitué par huit impulsions.

### Revendications

1. Procédé d'alignement automatique d'un objet muni d'une paire de mire d'alignement séparées par une distance déterminée d et présentant une certaine surface, par rapport à une référence, constituée par deux fenêtres d'analyse d'image (15, 15') séparées par la distance d et définissant un axe et un centre de référence, ledit procédé comportant les étapes suivantes :
— mise en place de l'objet sur une platine d'alignement ;
— préalignement grossier, au moyen de techniques connues, dudit objet de telle sorte que l'image optique agrandie de chaque mire d'alignement ($I_{MIR}$, $I_{MIR}'$) s'inscrive dans une fenêtre d'analyse d'image (15, 15') divisée en quadrants et dans laquelle l'image se trouve entièrement contenue ;
— génération, au centre de chaque fenêtre d'analyse (15, 15'), de l'image d'une mire de référence virtuelle ($I_{REF}$) de dimensions identiques à celle de l'image de la mire d'alignement ($I_{MIR}$, $I_{MIR}'$) et qui est superposée à cette dernière ;
— détermination, pour chaque mire et pour chaque quadrant i = 1, 2, 3, 4, des surfaces des parties de l'image de la mire d'alignement ($I_{MIR}$, $I_{MIR}'$) qui s'étendent au-delà du contour de l'image de la mire de référence ($I_{REF}$), c'est-à-dire non masquées par cette dernière et des surfaces des parties de l'image de la mire de référence ($I_{REF}$) qui s'étendent au-delà du contour de l'image de la mire d'alignement ($I_{MIR}$, $I_{MIR}'$), c'est-à-dire masquées par cette dernière, ces superficies étant respectivement appelées « non masquées » ($S_i^+$, $S_i^{+'}$) et « masquées » ($S_i^-$, $S_i^{-'}$) ;
— détermination par des moyens de calcul (21), à partir des valeurs desdites surfaces, des corrections en translation $\Delta X$, $\Delta Y$ et en rotation $\Delta\theta$ à apporter à ladite platine pour que l'objet qu'elle supporte, se trouve correctement aligné.

2. Procédé selon la revendication 1 caractérisé en ce que ledit objet est un substrat en céramique (10) et que lesdites mires d'alignement sont constituées par deux petites croix (14 ; 14') séparées par une distance d et formées simultanément avec la configuration de métallisation.

3. Procédé selon la revendication 1 ou 2 caractérisé en ce que les fenêtres d'analyse d'image (15, 15') sont constituées chacune par une matrice (15 ; 15') de N × N photodiodes et séparées par une distance d.

4. Procédé selon la revendication 3 caractérisé en ce que ladite étape de préalignement rend négligeable l'erreur en rotation ($\alpha$) et que pour ramener le centre de l'image d'une mire en forme de croix (N ; N') au centre ($N_0$, $N_0'$) de la fenêtre d'analyse (15, 15'), des corrections en translation $\Delta x$, $\Delta y$ ; $\Delta x'$, $\Delta y'$ suffisent.

5. Procédé selon la revendication 4 caractérisé en ce que les corrections en translation $\Delta x$, $\Delta y$ ; $\Delta x'$, $\Delta y'$ sont obtenues à partir d'un calcul des surfaces ($S_i^+$, $S_i^-$ ; $S_i^{+'}$, $S_i^-$) pour minimiser les effets des irrégularités dans la forme des croix, inhérentes au procédé de métallisation, en déterminant d'abord dans quel quadrant se trouve le centre N de l'image de la mire puis en appliquant les relations qui permettent le calcul de Δx, Δy ; Δx′, Δy′ correspondantes selon les indications de la table I suivante :

| ELEMENT CARACTERISTIQUE | CALCUL DES CORRECTIONS Δx et Δy |
|---|---|
| $S_1^- = 0$ | $\Delta x = \dfrac{(S_1^+ - S_4^-) + S_4^+}{H}$ $\qquad$ $\Delta y = \dfrac{(S_1^+ - S_2^-) + S_2^+}{H}$ |
| $S_3^- = 0$ | $\Delta x = \dfrac{(S_2^+ - S_3^-) + S_3^+}{H}$ $\qquad$ $\Delta y = \dfrac{(S_2^+ - S_1^-) + S_1^+}{H}$ |
| $S_3^- = 0$ | $\Delta x = \dfrac{(S_3^+ - S_2^-) + S_2^+}{H}$ $\qquad$ $\Delta y = \dfrac{(S_3^+ - S_4^-) + S_4^+}{H}$ |
| $S_4^- = 0$ | $\Delta x = \dfrac{(S_4^+ - S_1^-) + S_1^+)}{H}$ $\qquad$ $\Delta y = \dfrac{(S_4^+ - S_3^-) + S_3^+}{H}$ |

où $S_i^- = 0$ est la caractéristique du quadrant où se trouve le centre N de l'image de la mire et H est la hauteur de l'image de la croix d'alignement dans la fenêtre d'analyse.

6. Procédé selon la revendication 4 caractérisé en ce que les corrections en translation Δx, Δy ; Δx′, Δy′ sont obtenues à partir d'un calcul des surfaces ($S_i^+$, $S_i^-$ ; $S_i^{+\prime}$, $S_i^{-\prime}$) pour minimiser les effets des irrégularités dans la forme des croix, inhérentes au procédé de métallisation, en déterminant d'abord dans quel quadrant se trouve le centre N de l'image de la mire puis en appliquant les relations qui permettent le calcul de Δx, Δy ; Δx′, Δy′ correspondantes selon les indications de la table II suivante :

| ELEMENT CARACTERISTIQUE | CALCUL DES CORRECTIONS Δx et Δy |
|---|---|
| $S_1^- = 0$ | $\Delta x = \dfrac{(S_3^- + S_2^-) - S_2^+}{H}$ $\qquad$ $\Delta y = \dfrac{(S_3^- - S_4^+) + S_4^-}{H}$ |
| $S_3^- = 0$ | $\Delta x = \dfrac{(S_4^- + S_1^-) - S_1^+}{H}$ $\qquad$ $\Delta y = \dfrac{(S_4^- - S_3^+) + S_3^-}{H}$ |
| $S_3^- = 0$ | $\Delta x = \dfrac{(S_1^- + S_4^-) - S_4^+}{H}$ $\qquad$ $\Delta y = \dfrac{(S_1^- - S_2^+) + S_2^-}{H}$ |
| $S_4^- = 0$ | $\Delta x = \dfrac{(S_2^- + S_3^-) - S_3^+}{H}$ $\qquad$ $\Delta y = \dfrac{(S_2^- - S_1^+) + S_1^-}{H}$ |

7. Le procédé selon les revendications 5 et 6 caractérisé en ce que les corrections Δx, Δy et Δx′, Δy′ sont obtenues en faisant la moyenne des valeurs obtenues par les tables I et II.

8. Le procédé selon l'une des revendications 5, 6 ou 7 caractérisé en ce que les surfaces « non masquées » et « masquées » ($S_i^+$, $S_i^-$ ; $S_i^{+\prime}$, $S_i^{-\prime}$) sont déterminées par un calcul de traversée, c'est-à-dire que pour chaque ligne de la matrice de photodiodes balayée, on élabore des signaux dont la durée est proportionnelle au nombre de photodiodes traversées et référencées $s^+$, $s^{+\prime}$ pour les surfaces « non masquées » et $s^-$, $s^{-\prime}$ pour les surfaces « masquées » que ces signaux sont répartis selon les quadrants pour fournir des signaux ($s_i^+$, $s_i^-$ ; $s_i^{+\prime}$, $s_i^{-\prime}$) ; que ces derniers signaux sont échantillonnés en impulsions qui sont comptées dans des registres, dont le contenu à la fin du balayage de la fenêtre d'analyse est représentatif des surfaces ($S_1^+$, ... $S_4^-$ ; $S_1^{+\prime}$, ... $S_4^{-\prime}$).

9. Procédé selon la revendication 5, 6, 7 ou 8 caractérisé en ce que les corrections finales ΔX, ΔY, Δθ à apporter à la platine d'alignement pour l'alignement du substrat, sont données par les relations suivantes :

$$\Delta X = (\Delta x + \Delta x')/2, \quad \Delta Y = (\Delta y + \Delta y')/2, \quad \Delta\theta = (\Delta y - \Delta y')/2d$$

10. Equipement d'alignement automatique d'un objet muni d'une paire de mires d'alignement séparées par une distance déterminée d et présentant une certaine surface, par rapport à une référence constituée par deux fenêtres d'analyse (15, 15') séparées par la distance d et définissant un axe et un centre de référence, ledit équipement comportant les moyens suivants :

— des moyens de support (23) pouvant être commandés en translation et en rotation, supportant ledit objet ;

— des moyens d'analyse d'image (24, 18) comportant deux fenêtres d'analyse (15, 15'), dont chacune est divisée en quadrants, disposées de telle sorte que les images desdites mires d'alignement ($I_{MIR}$, $I_{MIR}'$) soient entièrement contenues dans lesdites fenêtres d'analyse, et fournissant un signal binaire ($I_{mir}$, $I_{mir}'$) pour chaque image analysée au moyen d'un balayage ligne par ligne desdites fenêtres ;

— des moyens de génération (25) d'un signal vidéo ($I_{ref}$) correspondant à l'image ($I_{REF}$) d'une mire de référence virtuelle, de dimensions identiques à celles de l'image de la mire d'alignement ($I_{mir}$, $I_{mir}'$) correspondante, le centre de ladite image ($I_{REF}$) coïncidant virtuellement avec celui de la fenêtre d'analyse ;

— des moyens de détermination (26, 27, 28, 29), pour chaque mire et pour chaque quadrant i = 1, 2, 3, 4, des surfaces des parties de l'image de la mire d'alignement ($I_{MIR}$, $I_{MIR}'$) qui s'étendent au-delà du contour de l'image de référence ($I_{REF}$) et des surfaces des parties de l'image de référence ($I_{REF}$) qui s'étendent au-delà du contour de l'image de la mire d'alignement ($I_{MIR}$, $I_{MIR}'$), ces parties étant respectivement appelées « non masquées » ($S_i^+$, $S_i^{+'}$) et « masquées » ($S_i^-$, $S_i^{-'}$) ; et

— des moyens de calcul (21), déterminant à partir des valeurs desdites surfaces, des corrections en translation $\Delta X$, $\Delta Y$ et en rotation $\Delta\theta$ à apporter à ladite platine pour que l'objet qu'elle supporte se trouve correctement aligné par rapport à la référence.

11. Equipement selon la revendication 10 caractérisé en ce que ledit objet est un substrat en céramique (10) et que lesdites mires d'alignement sont constituées par deux petites croix (14 ; 14') formées simultanément avec la configuration de métallisation.

12. Equipement selon la revendication 11 caractérisé en ce que les fenêtres d'analyse (15, 15') sont séparées par une distance d et qu'elles sont constituées chacune par une matrice de N × N photodiodes.

13. Equipement selon la revendication 12 caractérisé en ce que les moyens d'analyse (24) fournissent outre le signal binaire de l'image de chaque croix ($I_{mir}$ ; $I_{mir}'$), un signal de fin de ligne (RL) et un signal de fin d'image (FRAME), au rythme d'une horloge de synchronisation interne (HORLOGE).

14. Equipement selon la revendication 13 caractérisé en ce que les moyens de génération (25) du signal binaire ($I_{ref}$) représentatif de l'image de référence ($I_{REF}$) comprennent :

— des moyens de mémorisation adressables constitués par une mémoire de type ROM (38) associée à son compteur d'adresse (40), chargée par des mots binaires de n bits afin qu'ainsi pour une ligne de la matrice, p bits servent à indiquer le nombre de photodiodes balayées avant que l'image ne change d'état, le reste n — p bits sont des indicateurs d'état indiquant notamment la présence (N) ou l'absence (B) d'image ou encore la fin d'une ligne (RL), une même ligne pouvant exiger plusieurs mots ; chaque ligne est séparée de la suivante par un mot binaire spécial appelé séparateur(s) caractérisé par la seule présence du bit indicateur RL ;

— des moyens de décomptage (39) chargés par la valeur P qui décrémentent à partir de cette valeur jusqu'à 0 et dont la sortie attaque, d'une part une bascule de type D dont le niveau de sortie est fonction de la présence ou absence d'image pour fournir ($I_{ref}$), d'autre part, l'entrée commandant son chargement ainsi que l'incrémentation dudit compteur ; l'entrée de ladite bascule étant commandée par un des bits indicateurs N/B ; et,

— des moyens de synchronisation desdits moyens de décomptage.

15. Equipement selon la revendication 14 caractérisé en ce qu'il comporte en outre des moyens de blocage (46, 43) desdits moyens de décomptage pendant un délai déterminé, commandé par le signal de fin de ligne (RL).

16. Equipement selon la revendication 13 caractérisé en ce que lesdits moyens de détermination des parties « non masquées » et « masquées » comprennent :

— des moyens de calcul (27) des traversées ($s^+$, $s^-$, $s^{+'}$, $s^{-'}$) pour fournir des signaux correspondants indifférenciés selon les quadrants ;

— des moyens de détermination (26) du quadrant ($S_i$) ;

— des moyens de multiplexage et d'échantillonage (28) desdits signaux de traversée pour fournir des signaux ($s_i^+$, $s_i^-$ ; $s_i^{+'}$, $s_i^{-'}$) impulsionnels différenciés par quadrant ; et,

— des moyens de comptage (29) desdites impulsions par quadrant pour fournir lesdites surfaces « masquées » et « non masquées » ($S_i^+$, $S_i^-$ ; $S_i^{+'}$, $S_i^{-'}$).

## Claims

1. A method of automatically aligning an object provided with a pair of alignment marks separated by a predetermined distance « d » and having a given surface area, with respect to a reference comprised of two image inspection windows (15, 15') separated by said distance « d » and defining an axis of reference and a center of reference, said method comprising the steps of :

— placing said object on an alignment platen ;

— using known techniques to achieve a coarse prealignment of said object to cause the enlarged optical image of each alignment mark ($I_{MIR}$, $I_{MIR}'$) to be entirely contained within an image inspection window (15, 15') divided into quadrants ;

— generating in the center of each inspection window (15, 15') a reference mark's virtual image ($I_{REF}$) having the same size as the alignment mark's image ($I_{MIR}$, $I_{MIR}'$) and superimposed thereon ;

— determining, for each mark and for each quadrant i = 1, 2, 3, 4, the surface areas of those portions of the alignment mark's image ($I_{MIR}$, $I_{MIR}'$) which extend beyond the outline of the reference mark's image ($I_{REF}$), that is, which are not masked by the latter image and the surface areas of those portions of the reference mark's image ($I_{REF}$) which extend beyond the outline of the alignment mark's image ($I_{MIR}$, $I_{MIR}'$), that is, which are masked by the latter image, said surface areas being termed « exposed » ($S_i^+$, $S_i^{-'}$) and « masked » ($S_i^-$, $S_i^{-'}$), respectively ;

— using computation means (21) to determine form the values of said surface areas the translational error corrections $\Delta X$, $\Delta Y$ and the rotational error corrections $\Delta\theta$ required to adjust the position of said platen to cause the object thereon to be correctly aligned.

2. A method according to claim 1, characterized in that said object is a ceramic substrate (10) and in that said alignment marks consist of two small crosses (14, 14') separated by a distance « d » and formed simultaneously with the metallization pattern.

3. A method according to claim 1 or 2, characterized in that said image inspection windows (15, 15') are each comprised of a matrix of N × N photodiodes and are separated by a distance « d ».

4. A method according to claim 3, characterized in that said prealignment step renders the rotational error ($\alpha$) negligible and only requires that translational error corrections $\Delta x$, $\Delta y$ ; $\Delta x'$, $\Delta y'$ be made to cause the center (N, N') of the image of a cross-shaped mark to coincide with the center ($N_0$, $N_0'$) of the inspection window (15, 15').

5. A method according to claim 4, characterized in that said translational error corrections $\Delta x$, $\Delta y$ ; $\Delta x'$, $\Delta y'$ are derived from a computation of surface areas ($S_i^+$, $S_i^-$ ; $S_i^+$, $S_i^-$, $S_i^{-'}$) to minimize the effects of irregularities of the shapes of the crosses that are inherent in the metallization process, by first determining the quadrant wherein lies the center N of the image of the mark and by the applying the equations that permit computing corresponding corrections $\Delta x$, $\Delta y$ ; $\Delta x'$, $\Delta y'$, in accordance with Table I below :

Table I

| CHARACTERISTIC ELEMENT | COMPUTATION OF $\Delta x$ AND $\Delta y$ | |
|---|---|---|
| $S_1^- = 0$ | $\Delta x = \dfrac{(S_1^+ - S_4^-) + S_4^+}{H}$ | $\Delta y = \dfrac{(S_1^+ - S_2^-) + S_2^+}{H}$ |
| $S_3^- = 0$ | $\Delta x = \dfrac{(S_2^+ - S_3^-) + S_3^+}{H}$ | $\Delta y = \dfrac{(S_2^+ - S_1^-) + S_1^+}{H}$ |
| $S_3^- = 0$ | $\Delta x = \dfrac{(S_3^+ - S_2^-) + S_2^+}{H}$ | $\Delta y = \dfrac{(S_3^+ - S_4^-) + S_4^+}{H}$ |
| $S_4^- = 0$ | $\Delta x = \dfrac{(S_4^+ - S_1^-) + S_1^+)}{H}$ | $\Delta y = \dfrac{(S_4^+ - S_3^-) + S_3^+}{H}$ |

where $S_i^- = 0$ is the characteristic of the quadrant in which the center N of the image of the mark lies and H is the height of the image of the alignment cross in the inspection window.

6. A method according to claim 4, characterized in that the translational error corrections $\Delta x$, $\Delta y$ ; $\Delta x'$, $\Delta y'$ are derived from a computation of the surface areas ($S_i^+$, $S_i^-$ ; $S_i^{+'}$, $S_i^{-'}$) to minimize the effects of irregularities of the shape of the crosses that are inherent in the metallization process, by first determining the quadrant wherein lies the center N of the image of the mark, and by then applying the equations that permit computing the corresponding corrections $\Delta x$, $\Delta y$ ; $\Delta x'$, $\Delta y'$, in accordance with Table II below :

12

Table II

| CHARACTERISTIC ELEMENT | COMPUTATION OF $\Delta x$ AND $\Delta y$ |
|---|---|
| $S_1^- = 0$ | $\Delta x = \dfrac{(S_3^- + S_2^-) - S_2^+}{H}$ $\qquad$ $\Delta y = \dfrac{(S_3^- - S_4^+) + S_4^-}{H}$ |
| $S_3^- = 0$ | $\Delta x = \dfrac{(S_4^- + S_1^-) - S_1^+}{H}$ $\qquad$ $\Delta y = \dfrac{(S_4^- - S_3^+) + S_3^-}{H}$ |
| $S_3^- = 0$ | $\Delta x = \dfrac{(S_1^- + S_4^-) - S_4^+}{H}$ $\qquad$ $\Delta y = \dfrac{(S_1^- - S_2^+) + S_2^-}{H}$ |
| $S_4^- = 0$ | $\Delta x = \dfrac{(S_2^- + S_3^-) - S_3^+}{H}$ $\qquad$ $\Delta y = \dfrac{(S_2^- - S_1^+) + S_1^-}{H}$ |

7. A method according to claims 5 and 6, characterized in that corrections $\Delta x$, $\Delta y$ and $\Delta x'$, $\Delta y'$ are obtained by averaging the values provided by Tables I and II.

8. A method according to any one of claims 5, 6 and 7, characterized in that the « exposed » and « masked » surface areas ($S_i^+$, $S_i^-$; $S_i^{+'}$, $S_i^{-'}$) are determined by computing quantities representing activated diodes, that is, by developing, for each scanned line of the matrix of photodiodes, signals the duration of which is proportional to the number of activated photodiodes, said signals being designated $s^+$, $s^{+'}$ for the « exposed » surface areas and $s^-$, $s^{-'}$ for the « masked » surface areas ; in that said signals are distributed among the quadrants to provide signals ($s_i^+$, $s_i^-$; $s_i^{+'}$, $s_i^{-'}$) ; and in that the latter signals are sampled, with the resultant pulses being fed to counters the contents of which, after scanning the inspection window, will be representative of surface areas ($S_1^+$ ... $S_4^-$; $S_1^{+'}$ ... $S_4^{-'}$).

9. A method according to claim 5, 6, 7 or 8, characterized in that the final corrections $\Delta X$, $\Delta Y$, $\Delta \theta$ required to adjust the position of the alignment platen for the purpose of aligning the substrate are defined by the following equations :

$$\Delta X = (\Delta x + \Delta x')/2, \quad \Delta Y = (\Delta y + \Delta y')/2, \quad \Delta \theta = (\Delta y - \Delta y')/2d$$

10. Apparatus for automatically aligning an object provided with a pair of alignment marks separated by a predetermined distance « d » and having a given surface area, with respect to a reference comprised of two inspection windows (15, 15') separated by said distance « d » and defining both an axis of reference and a center of reference, said apparatus comprising the following means :

— support means (23), the translation and rotation of which can be controlled, for supporting said object ;

— image inspection means (24, 18) comprising two inspection windows (15, 15') divided each into quadrants and disposed so that the images of said alignement marks ($I_{MIR}$, $I_{MIR}'$) are fully contained in said windows, and generating a binary signal ($I_{mir}$, $I_{mir}'$) for each image inspected by scanning said windows line by line ;

— generation means (25) for generating a video signal ($I_{ref}$) corresponding to the virtual image ($I_{REF}$) of a reference mark having the same size as the image of the corresponding alignment mark ($I_{mir}$, $I_{mir}'$), the center of said image ($I_{REF}$) being virtually coincident with that of the inspection window ;

— means (26, 27, 28, 29) for determining, for each mark and for each quadrant i = 1, 2, 3, 4, the surface areas of those portions of the alignment mark's image ($I_{MIR}$, $I_{MIR}'$) which extend beyond the outline of the reference image ($I_{REF}$), and the surface areas of those portions of the reference image ($I_{REF}$) which extend beyond the outline of said alignment mark's image ($I_{MIR}$, $I_{MIR}'$), said surface areas being termed « exposed » ($S_i^+$, $S_i^{+'}$) and « masked » ($S_i^-$, $S_i^{-'}$), respectively ; and

— computation means (21) for determining from the values of said surface areas the translational error corrections $\Delta X$, $\Delta Y$ and the rotational error corrections $\Delta \theta$ required to adjust the position of said platen to cause the object theron to be correctly aligned with respect to the reference.

11. Apparatus according to claim 10, characterized in that said object is a ceramic substrate (10) and in that said alignment marks consist of two small crosses (14, 14') formed simultaneously with the metallization pattern.

12. Apparatus according to claim 11, characterized in that the inspection windows (15, 15') are separated by a distance « d » and in that each of them consists of a matrix of N × N photodiodes.

13. Apparatus according to claim 12, characterized in that said inspection means (24) generate, in addition to said binary signal representative of the image of each cross ($I_{min}$, $I_{mir}'$), an End of Line (RL) signal and an End of Image (FRAME) signal under the control of an internal synchronization clock (CLOCK).

14. Apparatus according to claim 13, characterized in that said means (25) for generating the binary signal ($I_{ref}$) representative of the reference image ($I_{REF}$) comprises :
— addressable storage means comprised of a read-only memory ROM (38) associated with an address counter (40) and loaded with n-bit binary words wherein, for a given line of the matrix, p bits indicate the number of photodiodes scanned prior to the image changing states and the remaining $n - p$ bits are state indicators denoting in particular the presence (B) or the absence (W) of an image of the end of a line (RL) ; a given line may require several such words and each line is separated from the next by a special binary word called a separator (s) characterized in that it only contains indicator bit RL ;
— count-down counter means (39) which is set to a count of P and is then decremented from P to zero and the output of which is applied, on the one hand, to a D-type latch the output level of which is a function of the presence or the absence of an image to suply signal ($I_{ref}$) and, on the other hand, to its Load input and to the incrementation input of said counter, the input of said latch being controlled by one of said B and W indicators ; and
— means for synchronizing said count-down counter means.

15. Apparatus according to claim 14, characterized in that it further comprises means (46, 43) for inhibiting said count-down counter means for a predetermined time interval under the control of the End of Line (RL) signal.

16. Apparatus according to claim 13, characterized in that said means for determining the « exposed » and « masked » areas comprises :
— means (27) for computing quantities $s^+$, $s^-$, $s^{+'}$, $s^{-'}$ to provide corresponding signals undifferentiated by quadrant ;
— means (26) for determining said quadrants ($S_i$) ;
— means (28) for multiplexing and sampling said signals corresponding to said quantities to provide pulse signals ($s_i^+$, $s_i^-$ ; $s_i^{+'}$, $s_i^{-'}$) differentiated by quadrant ; and
— counter means (29) for counting the number of said pulses per quadrant to determine said « masked » and « exposed » areas ($S_i^+$, $S_i^-$ ; $S_i^{+'}$, $S_i^{-'}$).

**Patentansprüche**

1. Automatisches Ausrichtverfahren eines Objekts, wobei dieses Verfahren zwei Zielscheiben umfasst, die durch einem bestimmten Abstand d voneinander getrennt sind und eine gewisse Oberfläche aufweisen gegenüber einer Referenzfläche, aus zwei Bildanalysefenstern (15, 15') bestehend, die durch den Abstand d voneinander getrennt sind und eine Achse sowie einen Referenzmittelpunkt definieren und das genannte Verfahren im weiteren folgende Schritte aufweist :
— Aufbringen des Objekts auf einer Ausrichtplatte,
— Grobes Vorausrichten des genannten Objekts mittels bekannter technischer Verfahren, so dass das vergrösserte optische Bild jeder Ausrichtzielscheibe ($I_{MIR}$, $I_{MIR}'$) in einem in Quadrante unterteilten Bildanalysefenster (15, 15') erscheint, das das ganze Bild enthält,
— In Mittelpunkt jedes Analysefensters (15, 15'), Generation des Bildes einer virtuellen Referenzzielscheibe ($I_{REF}$), deren Dimensionen dieselben wie die der Ausrichtzielscheibe ($I_{MIR}$, $I_{MIR}'$) sind und die der genannten Ausrichtzielscheibe überlagert wird,
— Für jede Zielscheibe und jeden Quadrant i = 1, 2, 3, 4, Bestimmung der Oberflächen der Teile des Ausrichtzielscheibenbildes ($I_{MIR}$, $I_{MIR}'$), die sich ausserhalb der Kontur der Referenzzielscheibe ($I_{REF}$) befinden, d. h. die durch diese Zielscheibe nicht verdeckt sind, und der Teile des Bildes der Referenzzielscheibe ($I_{REF}$), die sich ausserhalb der Kontur des Bildes der Ausrichtzielscheibe ($I_{MIR}$, $I_{MIR}'$) befinden, d. h. die durch diese Zielscheibe nicht verdeckt werden, wobei diese Oberflächen jeweils mit « nicht maskiert » ($S_i^+$, $S_i^{+'}$) und « maskiert » ($S_i^-$, $S_i^{-'}$) bezeichnet werden ;
— Rechnerische (21), auf den Werten der genannten Oberflächen gestützte Bestimmung der Translationskorrekturen ΔX, ΔY und der Rotationskorrektur Δθ für die Lage der genannten Platte, damit das von ihr getragene Objekt einwandfrei ausgericht ist.

2. Verfahren nach Anspruch I, dadurch gekennzeichnet, dass das genannte Objekt ein Keramiksubstrat (10) ist und dass die genannten Zielscheiben aus zwei kleinen Kreuzen (14, 14') bestehen, die durch einen Abstand d voneinander getrennt sind und gleichzeitig mit der Metallisierungskonfiguration erzeugt werden.

3. Verfahren nach Anspruch 1 oder 2, dadurch gekennzeichnet, dass die Bildanalysefenster (15, 15') jeweils aus einer Matrix (15, 15') von N × N Photodioden bestehen und dass sie durch einen Abstand d getrennt sind.

4. Verfahren nach Anspruch 3, dadurch gekennzeichnet, dass der genannte Vorausrichtungsschritt

den Rotationsfehler ($\alpha$) auf einen vernachlässigbaren Wert bringt und dass Translationskorrekturen $\Delta x$, $\Delta y$, $\Delta x'$, $\Delta y'$ allein ausreichen um den Mittelpunkt eines kreuzförmigen Zielbilds (N, N') in den Mittelpunkt ($N_0$, $N_0'$) des Analysefensters (15, 15') zu bringen.

5. Verfahren nach Anspruch, 4, dadurch gekennzeichnet, dass die genannten Translationskorrekturen $\Delta x$, $\Delta y$, $\Delta x'$, $\Delta y'$ durch Berechnung der Oberflächen ($S_i^+$, $S_i^{+'}$, $S_i^-$, $S_i^{-'}$) erhalten werden, um somit den Einfluss von Unregelmässigkeiten der Kreuzform, die dem Metallisierungsverfahren zuzuschreiben sind, zu minimieren, wozu zuerst festgestellt wird, in welchem Quadrant sich der Mittelpunkt N des Zielbildes befindet, und dann die Beziehungen angewandt werden, die die Berechnung der entsprechenden Werte für $\Delta x$, $\Delta y$, $\Delta x'$, $\Delta y'$ nach den Angaben der nachstehenden Tafel I ermöglichen :

| Kennzeichnendes Element | Berechnung der Korrekturen $\Delta x$ und $\Delta y$ |
|---|---|
| $S_1^- = 0$ | $$\Delta x = \frac{(S_1^+ - S_4^-) + S_4^+}{H} \qquad \Delta y = \frac{(S_1^+ - S_2^-) + S_2^+}{H}$$ |
| $S_3^- = 0$ | $$\Delta x = \frac{(S_2^+ - S_3^-) + S_3^+}{H} \qquad \Delta y = \frac{(S_2^+ - S_1^-) + S_1^+}{H}$$ |
| $S_3^- = 0$ | $$\Delta x = \frac{(S_3^+ - S_3^-) + S_2^+}{H} \qquad \Delta y = \frac{(S_3^+ - S_4^-) + S_4^+}{H}$$ |
| $S_4^- = 0$ | $$\Delta x = \frac{(S_4^+ - S_1^-) + S_1^+}{H} \qquad \Delta y = \frac{(S_4^+ - S_3^-) + S_3^+}{H}$$ |

in der $S_i^- = 0$ die Charakteristik des Quadranten ist, in dem sich der Mittelpunkt N des Zielscheibenbildes befindet, und H die Höhe des Ausrichtkreuzbildes im Analysefenster.

6. Verfahren nach Anspruch 4, dadurch gekennzeichnet, dass die Translationskorrekturen $\Delta x$, $\Delta y$, $\Delta x'$, $\Delta y'$ durch Berechnung der Oberflächen ($S_i^+$, $S_i^{+'}$ $S_i^-$, $Si^{-'}$) erhalten werden, um somit den Einfluss von Unregelmässigkeiten der Kreuzform, die dem Metallisierungsverfahren zuzuschreiben sind, zu minimieren, wozu zuerst festgestellt wird, in welchem Quadrant sich der Mittelpunkt N des Zielbildes befindet, und dann die Beziehungen angewandt werden, die die Berechnung der entsprechenden Werte für $\Delta x$, $\Delta y$, $\Delta x'$, $\Delta y'$ nach den Angaben der nachstehenden Tafel II ermöglichen :

(Siehe-Tabelle Seite 16 f.)

## 0 147 493

| Kennzeichnendes Element | Berechnung der Korrekturen $\Delta x$ und $\Delta y$ | |
|---|---|---|
| $S_1^- = 0$ | $\Delta x = \dfrac{(S_3^- + S_2^-) - S_2^+}{H}$ | $\Delta y = \dfrac{(S_3^- - S_4^+) + S_4^-}{H}$ |
| $S_3^- = 0$ | $\Delta x = \dfrac{(S_4^- + S_1^-) - S_1^+}{H}$ | $\Delta y = \dfrac{(S_4^- - S_3^+) + S_3^-}{H}$ |
| $S_3^- = 0$ | $\Delta x = \dfrac{(S_1^- + S_4^-) - S_4^+}{H}$ | $\Delta y = \dfrac{(S_1^- - S_2^+) + S_2^-}{H}$ |
| $S_4^- = 0$ | $\Delta x = \dfrac{(S_2^- + S_3^-) - S_3^+}{H}$ | $\Delta y = \dfrac{(S_2^- - S_1^+) + S_1^-}{H}$ |

7. Verfahren nach den Ansprüchen 5 und 6, dadurch gekennzeichnet, dass die Korrekturen $\Delta x$, $\Delta y$, $\Delta x'$, $\Delta y'$ durch Bestimmung des Mittelwertes der Werte, die aus den Tafeln I und II hervorgehen, erhalten werden.

8. Verfahren nach einem der Ansprüche 5, 6 oder 7, dadurch gekennzeichnet dass die « nicht maskierten » und « maskierten » Oberflächen ($S_i^+$, $S_i^-$; $S_i^{+'}$, $S_i^{-'}$) durch eine « Durchquerungsrechnung » bestimmt werden, d. h. dass für jede Zeile der Matrix der abgetasteten Photodioden Signale erarbeitet werden, deren Dauer im Verhältnis zur Anzahl der durchquerten, bei « nicht maskierten » Oberflächen mit $s^+$, $s^{+'}$ und bei « maskierten » Oberflächen mit $s^-$, $s^{-'}$ bezeichneten Photodioden steht ; dass diese Signale den Quadranten gemäss aufgeteilt werden, um die Signale ($s_i^+$, $s_i^-$; $s_i^{+'}$, $s_i^{-'}$) zu erstellen ; dass die letzteren in Impulse zerlegt werden, die in Registern gezählt werden, deren Inhalt am Ende des Abtastens des Analysefensters repräsentativ für die Oberflächen ($S_1^+$, ...., $S_4^-$; $S_1^{+'}$, ...., $S_4^{-'}$) ist.

9. Verfahren nach Anspruch 5, 6, 7 oder 8, dadurch gekennzeichnet dass die Endkorrekturen $\Delta X$, $\Delta Y$, $\Delta\theta$, die für die Ausrichtplatte zum Ausrichten des Substrats durchgeführt werden, durch folgende Beziehungen gegeben werden :

$$\Delta X = (\Delta x + \Delta x')/2, \quad \Delta Y = (\Delta y + \Delta y')/2, \quad \Delta\theta = (\Delta y - \Delta y')/2d$$

10. Gerät zum automatischen Ausrichten eines Objekts, wobei dieses Gerät zwei Zielscheiben umfasst, die durch einen bestimmten Abstand d voneinander getrennt sind und eine gewisse Oberfläche aufweisen gegenüber einer Referenzfläche, aus zwei Analysefenstern (15, 15') bestehend, die durch den Abstand d voneinander getrennt sind und eine Achse sowie einen Refenzmittelpunkt definieren und das genannte Gerät im weiteren folgende Mittel aufweist :

— Tragemittel (23), die in Translation und in Rotation gesteuert werden können und das genannte Objekt tragen ;

— Mittel zur Bildanalyse (24, 18) mit zwei Analysefenstern (15, 15'), die jeweils in Quadranten unterteilt und so angeordnet sind, dass die Bilder der genannten Ausrichtzielscheiben ($I_{MIR}$, $I_{MIR}'$) vollständig in den genannten Fenstern enthalten sind, und die für jedes analysierte Bild mittels linienweiser Abtastung dieser Fenster ein binäres Signal ($I_{mir}$, $I_{mir}'$) erstellen.

— Mittel (25) zur Generation eines Videosignals ($I_{ref}$), das dem Bild ($I_{REF}$) einer virtuellen Referenzzielscheibe entspricht, deren Dimensionen dieselben wie die des entsprechenden Bildes der Ausrichtzielscheibe ($I_{mir}$, $I_{mir}'$) sind, wobei der Mittelpunkt des genannten Bildes ($I_{REF}$) virtuell mit dem des Analysefensters übereinstimmt.

— Für jede Zielscheibe und jeden Quadrant i = 1, 2, 3, 4, Mittel zur Bestimmung der Oberflächen der Teile des Ausrichtzielscheibenbildes ($I_{MIR}$, $I_{MIR}'$), die sich ausserhalb der Kontur des Referenzbildes

($I_{REF}$) befinden, und der Oberflächen der Referenzbildteile ($I_{REF}$), die sich ausserhalb der Kontur des Bildes der Ausrichtzielscheibe ($I_{MIR}$, $I_{MIR}'$) befinden, wobei diese Bildteile jeweils mit « nicht maskiert » ($S_i^+$, $S_i^{+'}$) und « maskiert » ($S_i^-$, $S_i^{-'}$) bezeichnet werden ;

— Richenmittel (21), um auf die Werte der genannten Oberflächen gestützt, die Translationskorrekturen $\Delta X$, $\Delta Y$ und die Rotationskorrektur $\Delta\theta$ zu bestimmen, die an der genannten Platte vorzunehmen sind, damit das davon getragene Objekt im Verhältnis zur Referenz einwandfrei ausgerichtet wird.

11. Gerät nach Anspruch 10, dadurch gekennzeichnet, dass das genannte Objekt ein Keramiksubstrat (10) ist und dass die genannten Zielscheiben aus zwei kleinen Kreuzen (14, 14') bestehen die zusammen mit der Metallisierungskonfiguration erzeugt werden.

12. Gerät nach Anspruch 11, dadurch gekennzeichnet, dass die Bildanalysefenster (15, 15') jeweils aus einer Matrix (15, 15') von $N \times N$ Photodioden bestehen und dass sie durch einen Abstand d voneinander getrennt sind.

13. Gerät nach Anspruch 12, dadurch gekennzeichnet, dass die Analysemittel (24) neben dem binären Signal für das Bild jedes Kreuzes ($I_{mir}$ ; $I_{mir}'$) auch noch dem Rhythmus eines internen Synchronisations-Taktgebers (CLOCK) folgend ein Signal für das Zeilenende (RL) und ein Signal für das Bildende (FRAMER) erarbeiten.

14. Gerät nach Anspruch 13, dadurch gekennzeichnet, dass die Generationsmittel (25) des binären Signals ($I_{ref}$), das repräsentativ für das Referenzbild ($I_{REF}$) ist, umfassen :

— adressierbare Einspeichermittel, aus einem Speicher vom ROM-Typ (38), zu dem ein Adressenzähler (40) gehört, bestehend, der mit binären Worten von n Bits geladen wird, damit derart für eine Reihe der Matrix p Bits geladen wird, damit derart für eine Reihe des Matrix p Bits zur Anzeige der Anzahl der abgetasteten Photodioden dienen bevor das Bild seinen Zustand ändert und die restlichen n — p Bits als Statusanzeiger fungieren, die insbesondere die Gegenwart (N) oder die Abwesenheit (B) eines Bildes anzeigen oder auch das Ende einer Zeile (RL), wobei dieselbe Zeile mehrere Worte erfordern kann und jede Zeile von der folgenden durch ein besonderes binäres Wort, Separator genannt und durch die alleinige Gegenwart des Anzeigebits RL gekennzeichnet, getrennt ist ;

— Abwärtszählmittel (39), die mit dem Wert P geladen werden und von diesem Wert ausgehend bis auf 0 zurückzählen und deren Ausgang einerseits und einer Kippschaltung von D-Typ liegt mit einem Ausgangspegel, der von der Gegenwart oder der Abwesenheit eines Bildes abhängt, um ($I_{ref}$) zu erstellen, und anderseits am Eingang, der das Laden sowie die Inkrementierung des genannten Zählers steuert, wobei der Eingang der genannten Kippschaltung von einem der Anzeigebits N/B gesteuert wird ; und

— Synchronisiermittel für die genannten Abwärtszählmittel.

15. Gerät nach Anspruch 14, dadurch gekennzeichnet, dass es des weiteren Sperrmittel (46, 43) für die genannten Abwärtszählmittel während eines bestimmten, vom Zeilenendesignal (RL) abhängigen Zeitraums aufweist.

16. Gerät nach Anspruch 13, dadurch gekennzeichnet, dass die genannten Mittel zur Bestimmung der « nicht maskierten » und der « maskierten » Teile aufweisen :

— Berechnungsmittel (27) der Durchquerungen ($s^+$, $s^-$, $s^{+'}$, $s^{-'}$), um entsprechende, nach den Quadranten differenzierte Signale zu erstellen ;

— Bestimmungsmittel (26) des Quadranten ($S_i$) ;

— Multiplex- und Stückelungsmittel (28) der genannten Durchquerungssignale, um differenzierte Impulssignale ($s_i^+$, $s_i^-$ ; $S_i^{+'}$, $s_i^{-'}$) pro Quadrant zu erstellen ; und

— Zählmittel (29) der genannten Impulse, um die genannten « maskierten » und « nicht maskierten » Oberflächen ($s_i^+$, $s_i^-$ ; $s_i^{+'}$, $s_i^{-'}$) zu definieren.

**0 147 493**

FIG. I

FIG. 2

**FIG.3**

**FIG.4**

| | |
|---|---|
| PRE - ALIGNEMENT DU SUBSTRAT POUR OBTENIR UNE IMAGE AGRANDIE DE LA CROIX DANS LA FENÊTRE D'ANALYSE. | ETAPE 1 |
| GÉNÉRATION D'UNE CROIX DE RÉFÉRENCE VIRTUELLE IDENTIQUE AU CENTRE DE LA FENÊTRE. | ETAPE 2 |
| CALCUL DES SURFACES POUR CHAQUE CROIX POUR CHAQUE QUADRANT : $S_i^+, S_i^-; S_i'^+, S_i'^-, (i=1,2,3,4)$ | ETAPE 3 |
| DETERMINATION DU QUADRANT CONTENANT LE CENTRE DE L'IMAGE ET DES FORMULES A APPLIQUER. | ETAPE 4 |
| CALCUL DE $\Delta x, \Delta y$, POUR LA PREMIERE CROIX $\Delta x', \Delta y'$, POUR LA DEUXIEME CROIX. | ETAPE 5 |
| CALCUL DES CORRECTIONS $\Delta X, \Delta Y$ ET $\Delta \theta$ | ETAPE 6 |
| ALIGNEMENT DU SUBSTRAT PAR APPLICATION DE CES CORRECTIONS. | ETAPE 7 |

# FIG. 5

3

FIG.6

FIG. 7

FIG. 8

FIG. 9A

FIG. 9B

FIG. IO

# FIG.II

# FIG.12